# EUROPEAN PATENT APPLICATION

(11) **EP 4 835 676 A1**
(43) Date of publication of application: **04.11.2026**
(21) Application number: 24912559.2
(22) Date of filing: 18.12.2024
(51) Int. Cl.: G06F 12/00, G11C 7/06, G11C 11/16, H03K 19/20

(54) **LOGIC OPERATION CIRCUIT**

(30) Priority: 27.12.2023 JP 2023221803
(71) Applicant: Sony Semiconductor Solutions Corporation, Atsugi-shi, Kanagawa 243-0014 (JP)
(72) Inventor: HIRAIRI, Koji, Atsugi-shi, Kanagawa 243-0014 (JP); HIRAGA, Keizo, Atsugi-shi, Kanagawa 243-0014 (JP); TANIMOTO, Tadaaki, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/044714
(87) International publication number: WO 2025/142670

(57) **Abstract**

Provided is a logical operation circuit that includes a differential logic tree cell, and a digital differential sense amplifier that reads an operation result of the differential logic tree cell. The differential logic tree cell includes a memory cell including first and second magnetic storage elements that store data in response to a change in a resistance value, and a differential logic circuit that performs a logical operation with use of the data stored in the memory cell and external data input from the outside. The digital differential sense amplifier is grounded without passing through the differential logic tree cell.

## Description

### Technical Field

The present disclosure relates to a logical operation circuit.

### Background Art

In recent years, with the rapid advancement of various information devices including large-capacity servers to mobile terminals, higher performance, such as higher integration, higher speed, and lower power consumption, has been pursued also with respect to elements such as memories and logics constituting those information devices. In particular, the progress in nonvolatile semiconductor memories is remarkable. For example, the use of flash memories, which serve as large-capacity file memories, has been becoming more common at an accelerating rate, with flash memories replacing hard disk drives. On the other hand, in anticipation of their application in the form of code storage and further as working memories, development of various types of semiconductor memories, such as ferroelectric random access memories (FeRAMs), magnetic random access memories (MRAMs), phase-change random access memories (PCRAMs), and the like, has been promoted to replace NOR flash memories, dynamic random access memories (DRAMs) and the like, which are currently used in general. Note that some of these memories have already been put into practical use.

The MRAM (storage device), which is one of the above-described memories, stores data by using the fact that the electric resistance changes when the magnetization state of a magnetic material of a magnetic storage element included in the MRAM is changed. Such an MRAM is capable of high-speed operation and also of almost infinite (10¹⁵ times or more) rewriting, and further has high reliability. Thus, the MRAM has been already used in the fields of industrial automation, aircrafts, and the like. Furthermore, in the future, the MRAM is expected to be used for the code storage and the working memories because of their high-speed operation and high reliability.

An MRAM of the related art includes a plurality of memory cells, and each of the memory cells includes one magnetic tunnel junction (MTJ) element (magnetic storage element) and one access transistor, and has a so-called 1T1R configuration. Then, the MRAM stores data with "1" and "0" by associating the data with a high resistance state and a low resistance state of the MTJ element included in one memory cell serving as one storage unit. Further, when reading data from such a memory cell, the reading is performed by detecting, using a sense amplifier, a difference in the voltage (or a difference in the current) between the MTJ element and a reference cell that is set to a value corresponding to an intermediate state between the high resistance state and the low resistance state of the MTJ element.

### Citation List

### Patent Literature

PTL 1: JP 2003-187569 A
PTL 2: JP 2001-236781 A
PTL 3: JP 2022-60143 A
PTL 4: JP 2023-516343 A
PTL 5: JP 2001-185999 A

### Non Patent Literature

NPL 1: Sudha Vani Yamani et al., "Design and Performance Benchmarking of Hybrid Tunnel FET/STT-MTJ-Based Logic In-Memory Designs for Energy Efficiency", IEEE Transactions on Magnetics, Vol. 58, No. 4, April, 2022
NPL 2: Gajanan Jedhe etal., "A 12 nm 137 TOPS/W Digital Compute-In-Memory using Foundary 8T SRAM Bitcell supporting 16 Kernel Weight Sets for AI Edge Applications", 2023 Symposium on VLSL Technology and Circuits Digest of Technical Papers

### Summary

### Technical Problem

Incidentally, in the MRAM (storage device) of the related art, the sense amplifier used for reading the data from the memory cell is not provided in the vicinity of each of the memory cells, but one sense amplifier is provided so as to correspond to a predetermined number of the memory cells. Therefore, the length of a wiring line connecting each of the memory cells and the reference cell is different from one memory cell to another. Therefore, a parasitic resistance value, which is caused by the wiring lines having different lengths, is added to the resistance value of each of the memory cells. Thus, even if the reference cell has an ideal intermediate resistance value, a margin (read margin) of the resistance value between the memory cell and the reference cell becomes narrow depending on the positional relationship between the memory cell and the reference cell, and it becomes difficult to read the data from the memory cell with high accuracy using the sense amplifier. Therefore, it is conceivable to provide the sense amplifier corresponding to each of the memory cells in the vicinity of the memory cell, but this leads to an increase in the chip area, and is therefore not preferable.

Therefore, the present disclosure proposes a logical operation circuit that can read data with high accuracy while avoiding an increase in the chip area, can operate at a higher speed if the power supply voltage is the same, and can operate at a lower power supply voltage if the operation speed is the same.

### Solution to Problem

According to the present disclosure, a logical operation circuit is provided that includes a differential logic tree cell, and a digital differential sense amplifier configured to read an operation result of the differential logic tree cell. The differential logic tree cell includes a memory cell including first and second magnetic storage elements configured to store data in response to a change in a resistance value, and a differential logic circuit configured to perform a logical operation with use of the data stored in the memory cell and external data input from the outside. The digital differential sense amplifier is grounded without passing through the differential logic tree cell.

### Brief Description of Drawings

[Fig. 1]

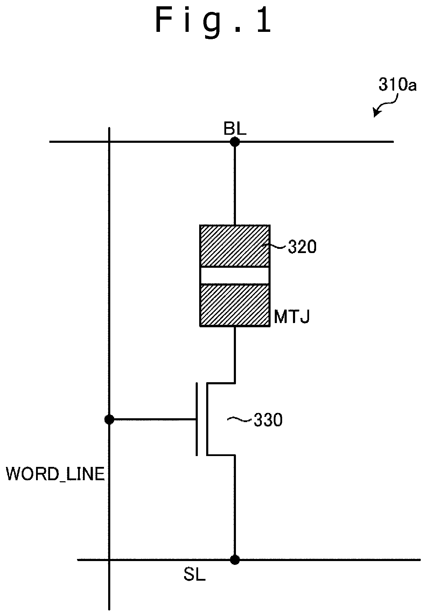

   Fig. 1 is a diagram illustrating a circuit configuration of a memory cell 310a according to the related art.
[Fig. 2]

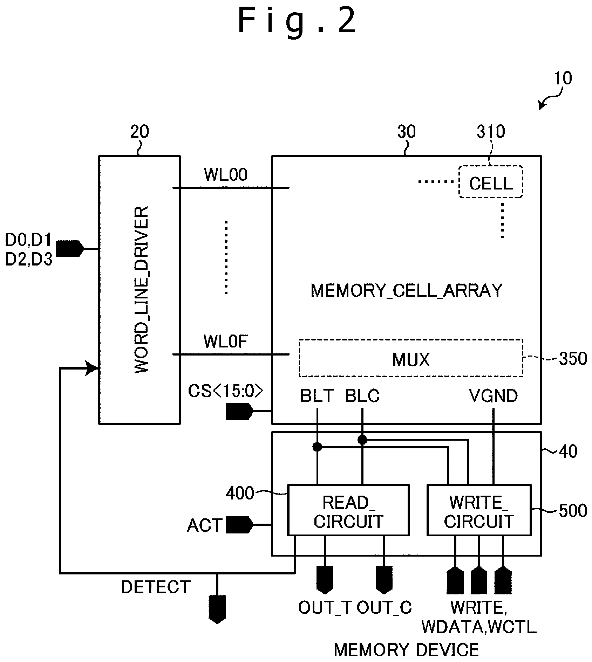

   Fig. 2 is a diagram illustrating a configuration example of an MRAM 10 according to a first embodiment of the present disclosure.
[Fig. 3]

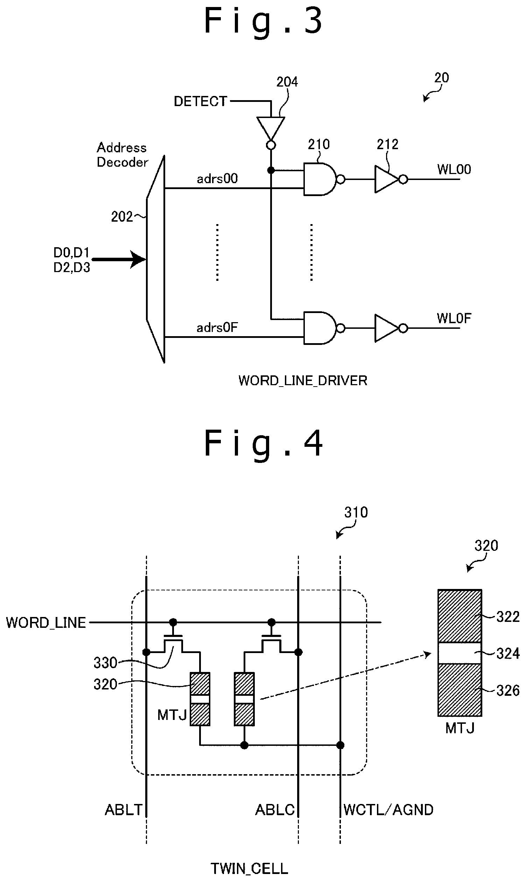

   Fig. 3 is a diagram illustrating a circuit configuration example of a word line driver 20 according to the first embodiment of the present disclosure.
[Fig. 4]
   Fig. 4 is a diagram illustrating a circuit configuration example of a memory cell 310 according to the first embodiment of the present disclosure.
[Fig. 5]

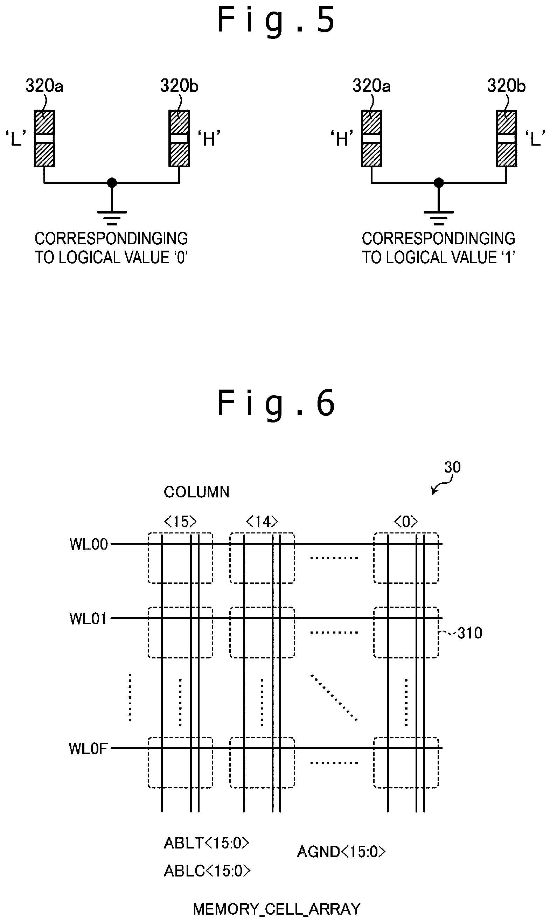

   Fig. 5 is a diagram for explaining an operation of the memory cell 310 to the first embodiment of the present disclosure.
[Fig. 6]
   Fig. 6 is a diagram illustrating a configuration example of a memory cell array 30 according to the first embodiment of the present disclosure.
[Fig. 7]

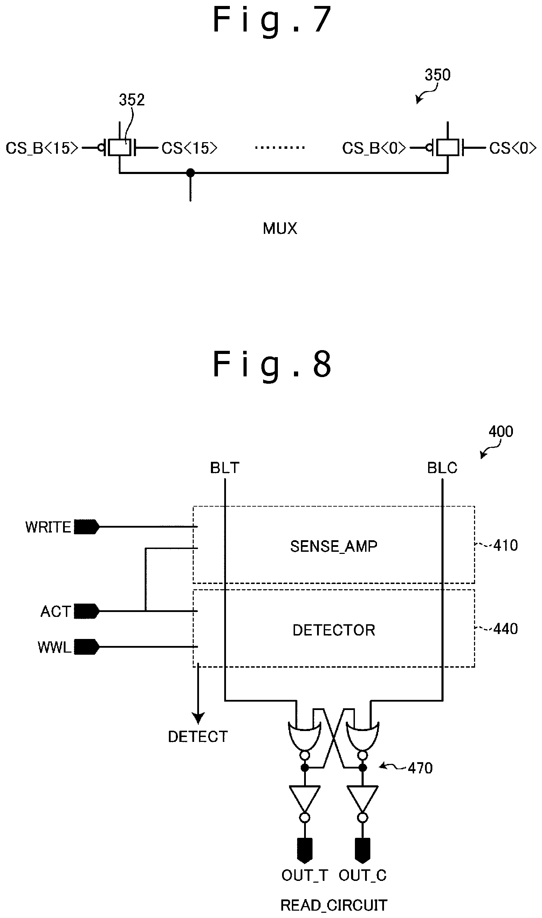

   Fig. 7 is a diagram illustrating a configuration example of a multiplexer circuit 350 according to the first embodiment of the present disclosure.
[Fig. 8]
   Fig. 8 is a diagram illustrating a configuration example of a read circuit 400 according to the first embodiment of the present disclosure.
[Fig. 9]

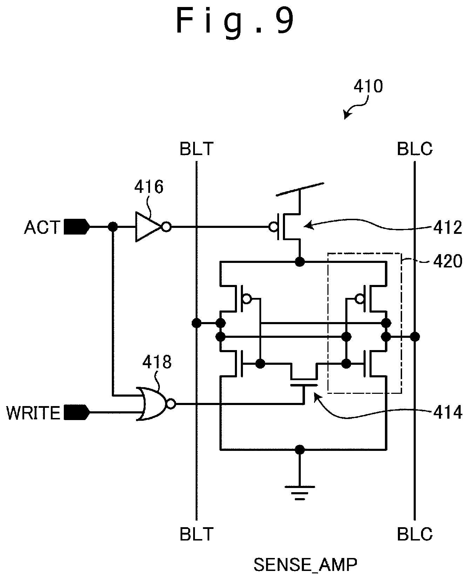

   Fig. 9 is a diagram illustrating a circuit configuration example of a sense amplifier 410 according to the first embodiment of the present disclosure.
[Fig. 10]

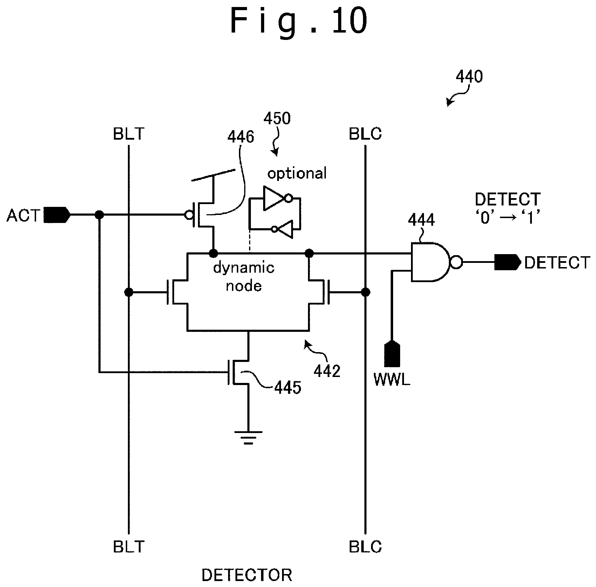

   Fig. 10 is a diagram illustrating a circuit configuration example of a detector circuit 440 according to the first embodiment of the present disclosure.
[Fig. 11]

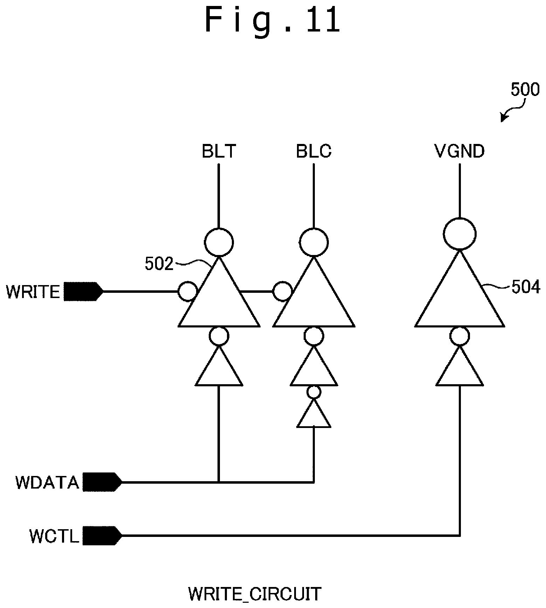

   Fig. 11 is a diagram illustrating a circuit configuration example of a write circuit 500 according to the first embodiment of the present disclosure.
[Fig. 12A]

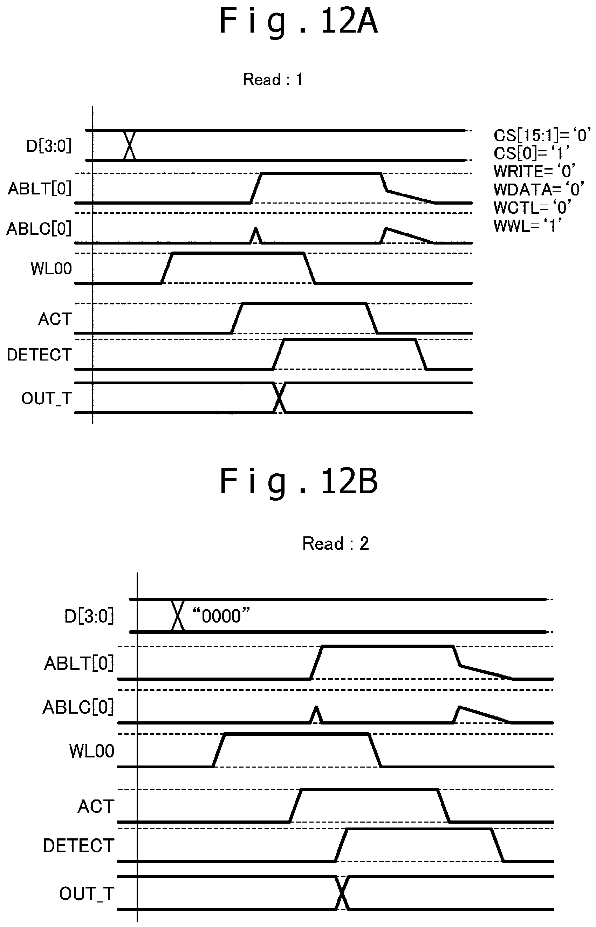

   Fig. 12A is a diagram (part 1) for explaining a read operation of the MRAM 10 according to the first embodiment of the present disclosure.
[Fig. 12B]
   Fig. 12B is a diagram (part 2) for explaining the read operation of the MRAM 10 according to the first embodiment of the present disclosure.
[Fig. 12C]

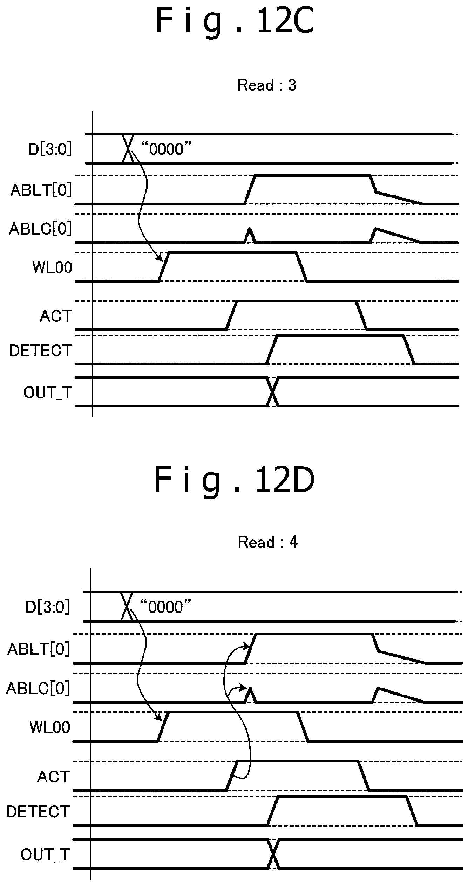

   Fig. 12C is a diagram (part 3) for explaining the read operation of the MRAM 10 according to the first embodiment of the present disclosure.
[Fig. 12D]
   Fig. 12D is a diagram (part 4) for explaining the read operation of the MRAM 10 according to the first embodiment of the present disclosure.
[Fig. 12E]

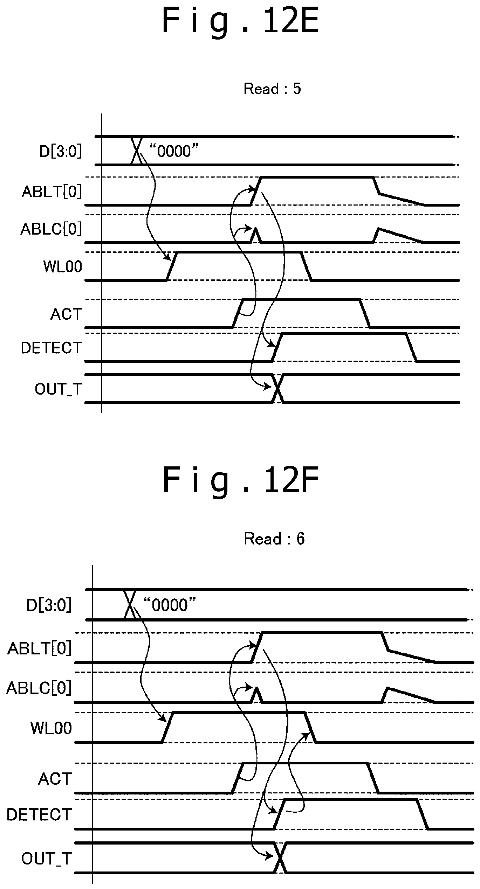

   Fig. 12E is a diagram (part 5) for explaining the read operation of the MRAM 10 according to the first embodiment of the present disclosure.
[Fig. 12F]
   Fig. 12F is a diagram (part 6) for explaining the read operation of the MRAM 10 according to the first embodiment of the present disclosure.
[Fig. 12G]

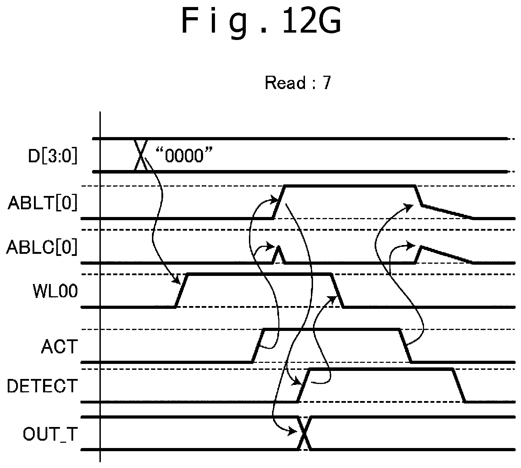

   Fig. 12G is a diagram (part 7) for explaining the read operation of the MRAM 10 according to the first embodiment of the present disclosure.
[Fig. 13A]

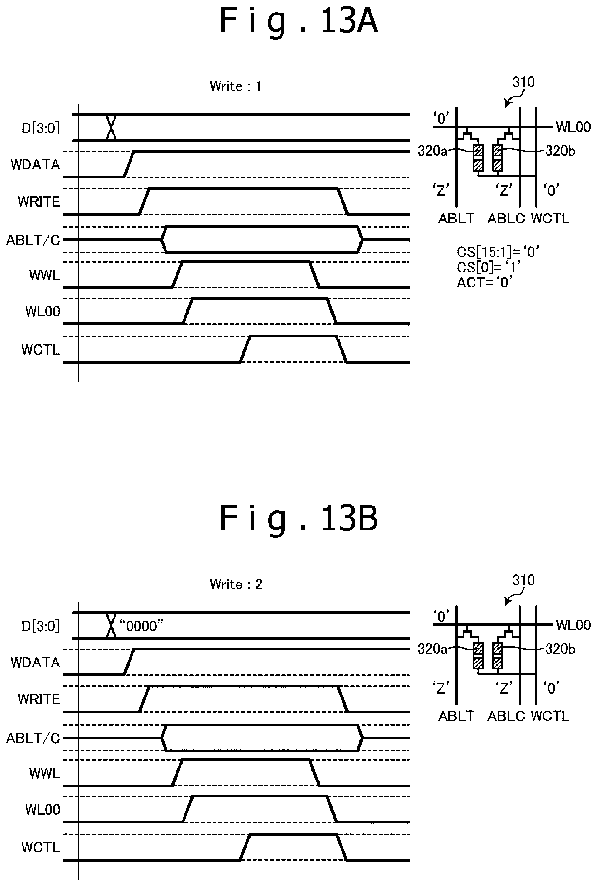

   Fig. 13A is a diagram (part 1) for explaining a write operation of the MRAM 10 according to the first embodiment of the present disclosure.
[Fig. 13B]
   Fig. 13B is a diagram (part 2) for explaining the write operation of the MRAM 10 according to the first embodiment of the present disclosure.
[Fig. 13C]

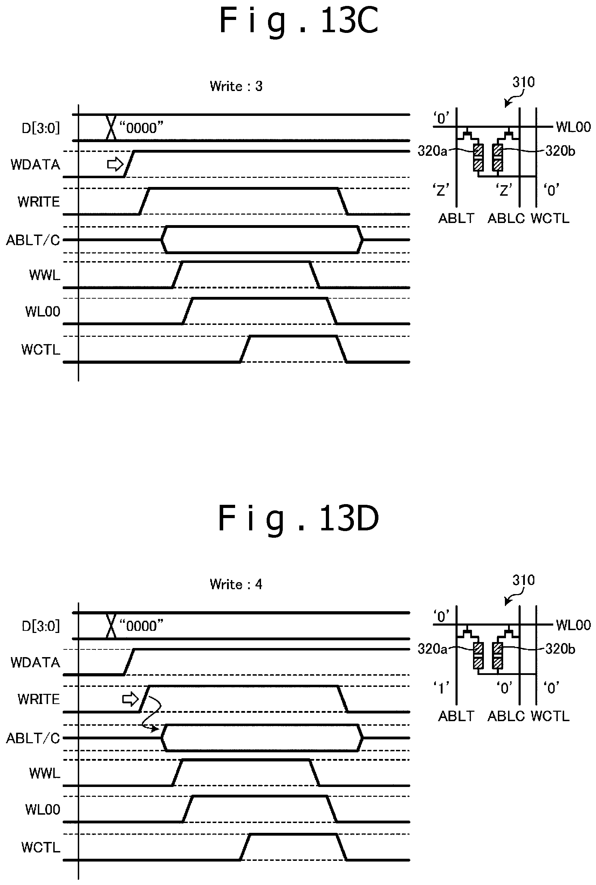

   Fig. 13C is a diagram (part 3) for explaining the write operation of the MRAM 10 according to the first embodiment of the present disclosure.
[Fig. 13D]
   Fig. 13D is a diagram (part 4) for explaining the write operation of the MRAM 10 according to the first embodiment of the present disclosure.
[Fig. 13E]

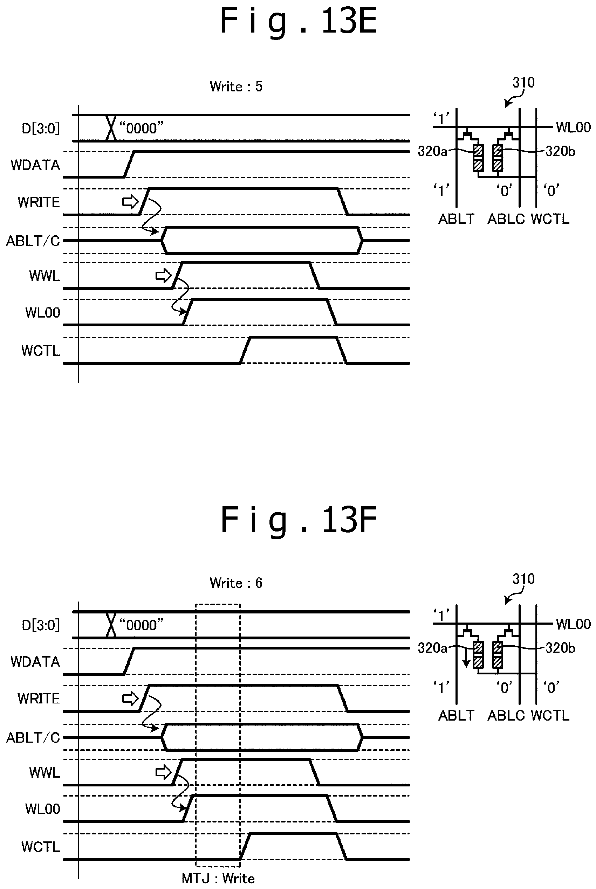

   Fig. 13E is a diagram (part 5) for explaining the write operation of the MRAM 10 according to the first embodiment of the present disclosure.
[Fig. 13F]
   Fig. 13F is a diagram (part 6) for explaining the write operation of the MRAM 10 according to the first embodiment of the present disclosure.
[Fig. 13G]

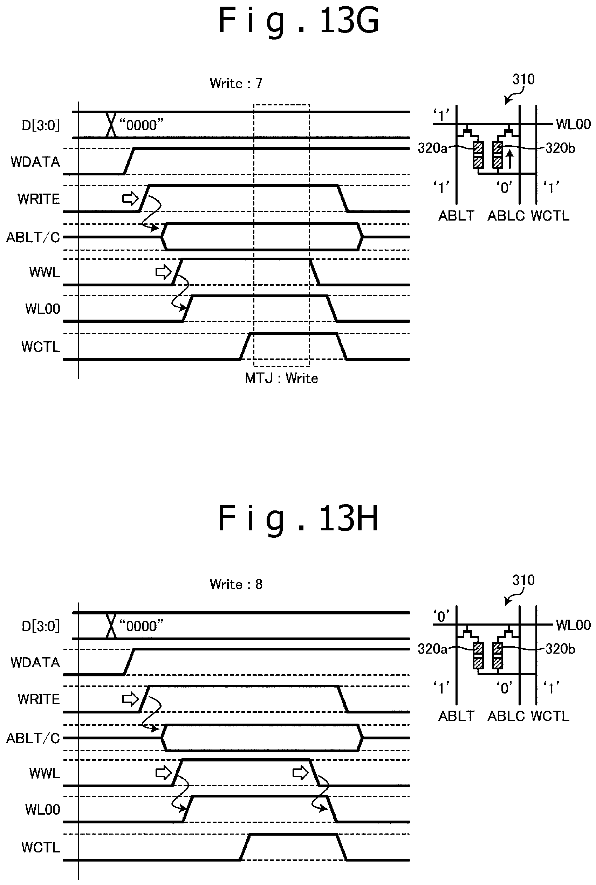

   Fig. 13G is a diagram (part 7) for explaining the write operation of the MRAM 10 according to the first embodiment of the present disclosure.
[Fig. 13H]
   Fig. 13H is a diagram (part 8) for explaining the write operation of the MRAM 10 according to the first embodiment of the present disclosure.
[Fig. 13I]

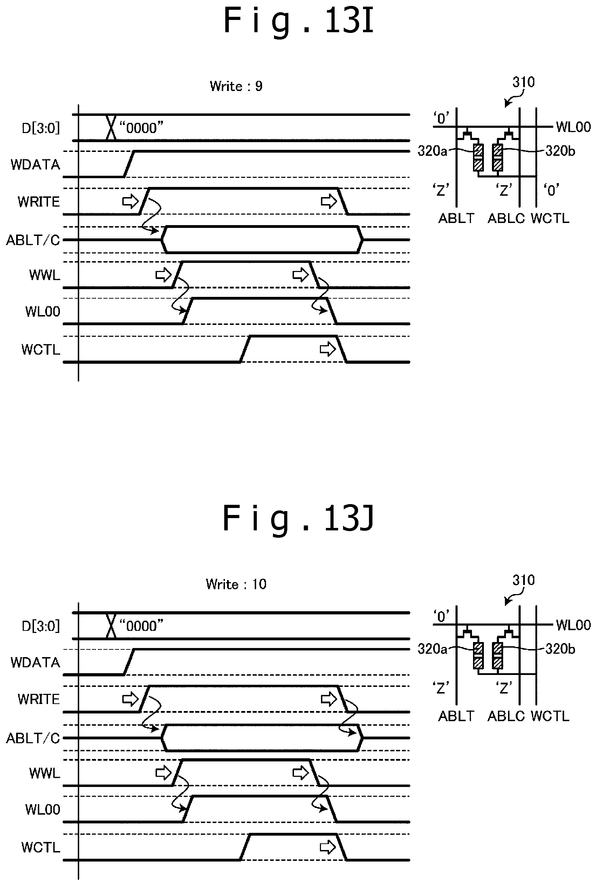

   Fig. 13I is a diagram (part 9) for explaining the write operation of the MRAM 10 according to the first embodiment of the present disclosure.
[Fig. 13J]
   Fig. 13J is a diagram (part 10) for explaining the write operation of the MRAM 10 according to the first embodiment of the present disclosure.
[Fig. 14]

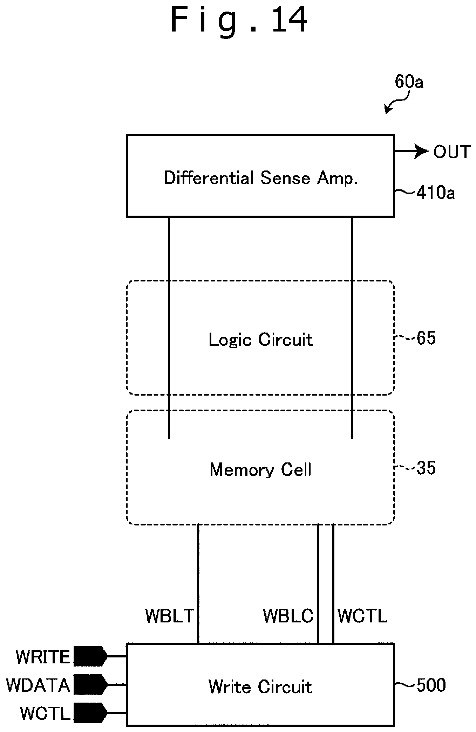

   Fig. 14 is a diagram illustrating a configuration of a logical operation circuit 60a according to the related art.
[Fig. 15]

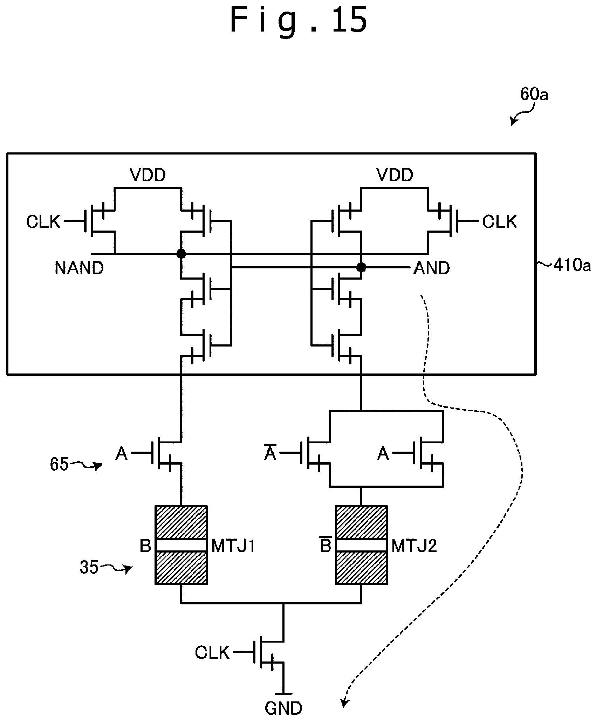

   Fig. 15 is a diagram illustrating a circuit configuration of the logical operation circuit 60a according to the related art.
[Fig. 16]

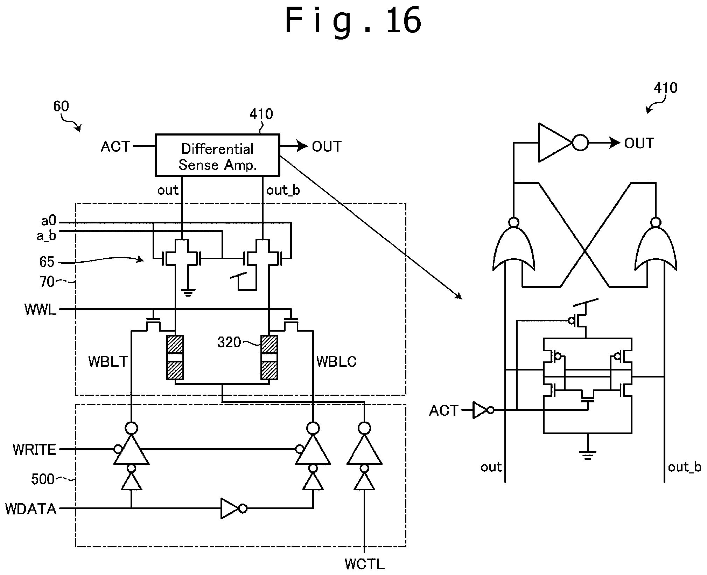

   Fig. 16 is a diagram for explaining an outline of a logical operation circuit 60 according to a second embodiment of the present disclosure.
[Fig. 17]

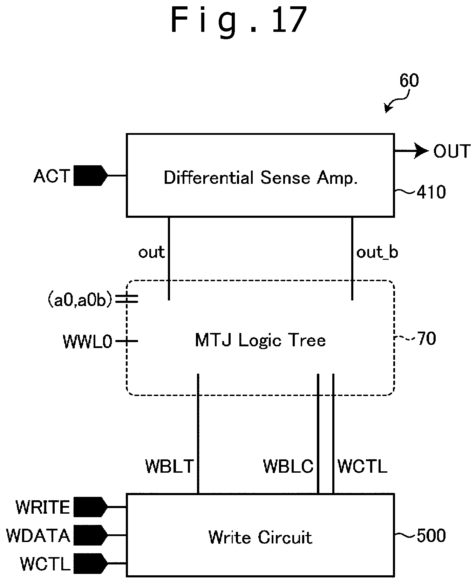

   Fig. 17 is a diagram illustrating a configuration example of the logical operation circuit 60 according to the second embodiment of the present disclosure.
[Fig. 18]

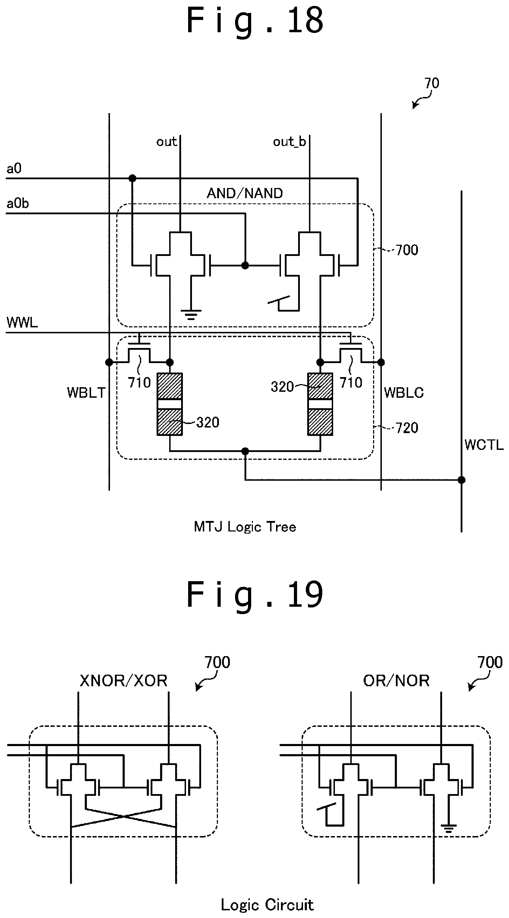

   Fig. 18 is a diagram illustrating a circuit configuration example of a differential logic tree cell 70 according to the second embodiment of the present disclosure.
[Fig. 19]
   Fig. 19 is a diagram illustrating a circuit configuration example of a differential-type logic circuit 700 according to the second embodiment of the present disclosure.
[Fig. 20]

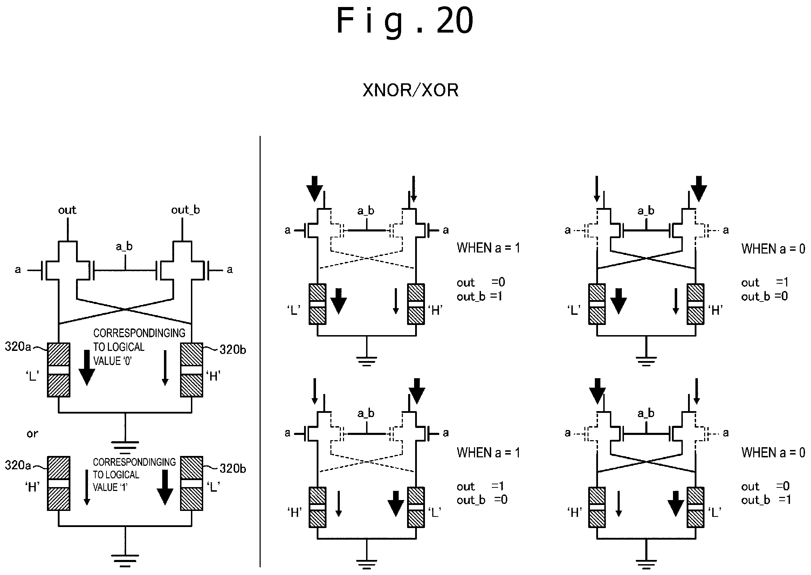

   Fig. 20 is a diagram (part 1) for explaining an operation of the differential logic tree cell 70 according to the second embodiment of the present disclosure.
[Fig. 21]

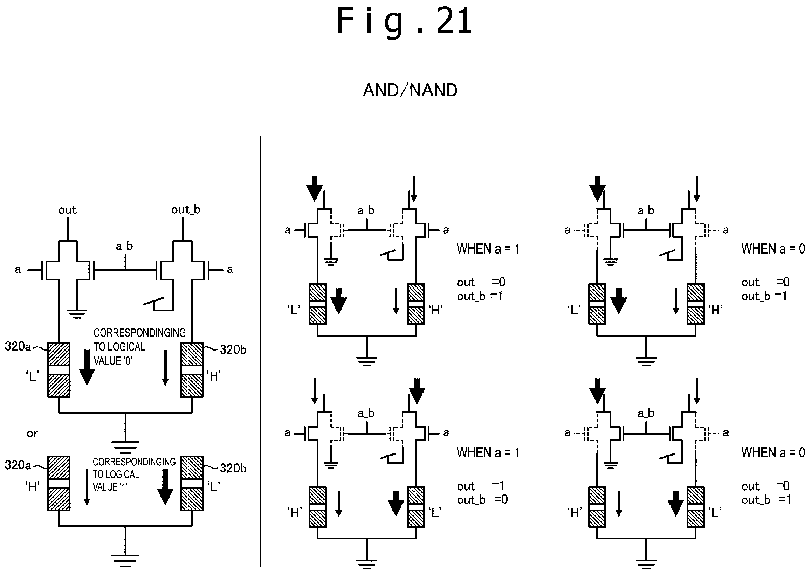

   Fig. 21 is a diagram (part 2) for explaining the operation of the differential logic tree cell 70 according to the second embodiment of the present disclosure.
[Fig. 22]

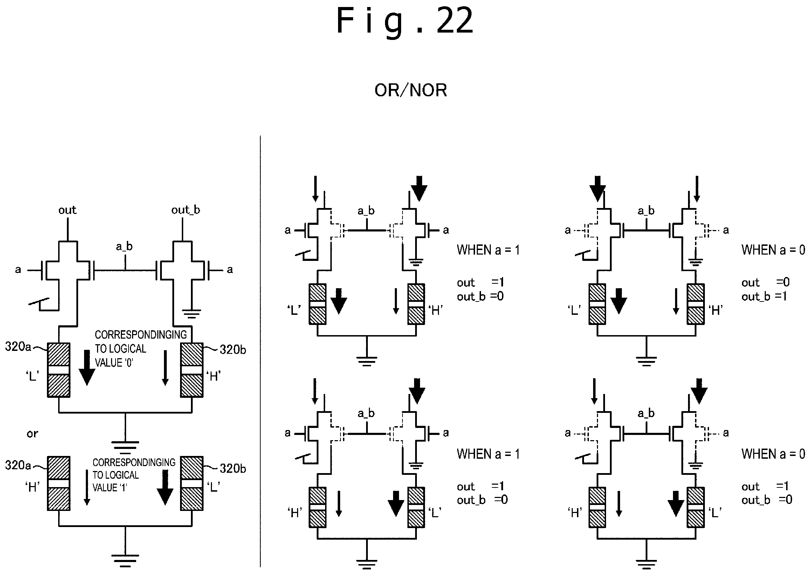

   Fig. 22 is a diagram (part 3) for explaining the operation of the differential logic tree cell 70 according to the second embodiment of the present disclosure.
[Fig. 23]

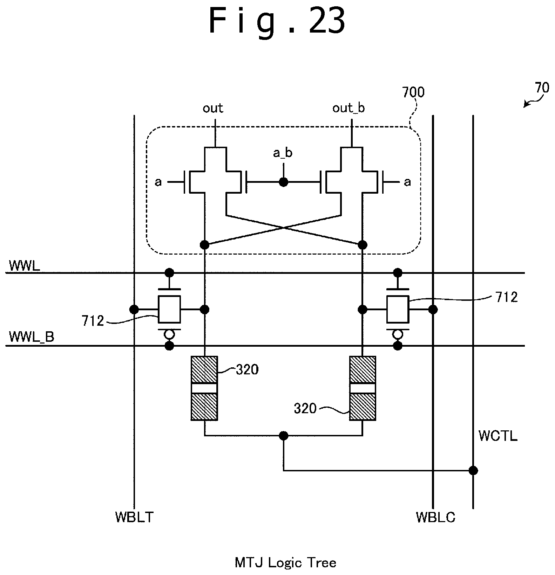

   Fig. 23 is a diagram (part 1) illustrating a circuit configuration example of the differential logic tree cell 70 according to a modification example of the second embodiment of the present disclosure.
[Fig. 24]

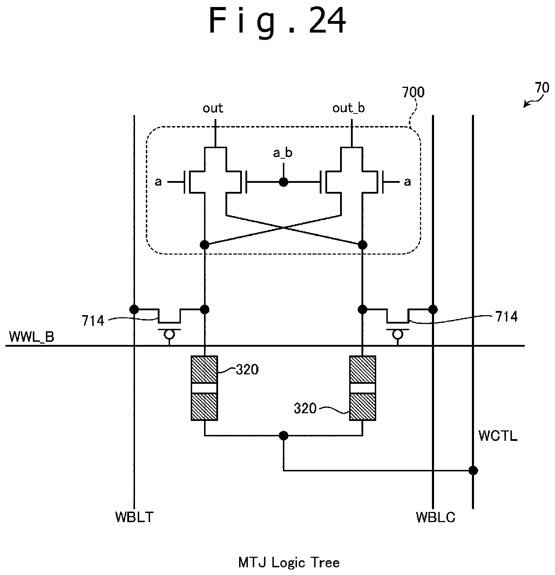

   Fig. 24 is a diagram (part 2) illustrating the circuit configuration example of the differential logic tree cell 70 according to the modification example of the second embodiment of the present disclosure.
[Fig. 25]

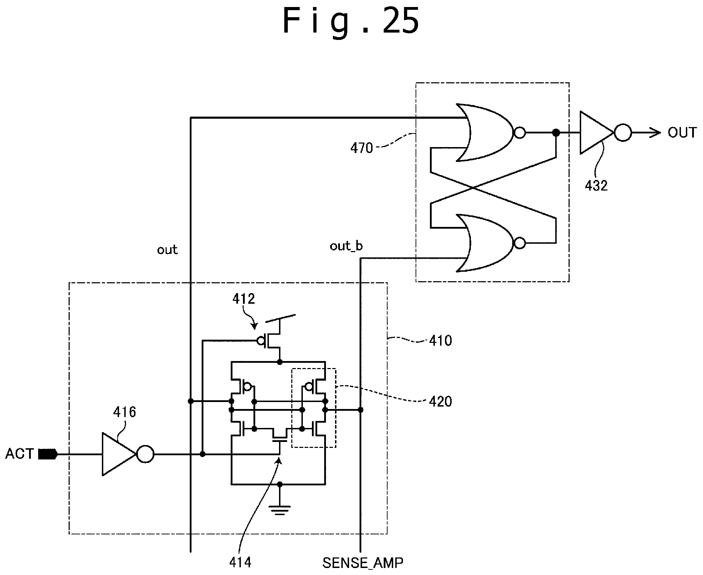

   Fig. 25 is a diagram illustrating a circuit configuration example of the sense amplifier 410 according to the second embodiment of the present disclosure.
[Fig. 26]

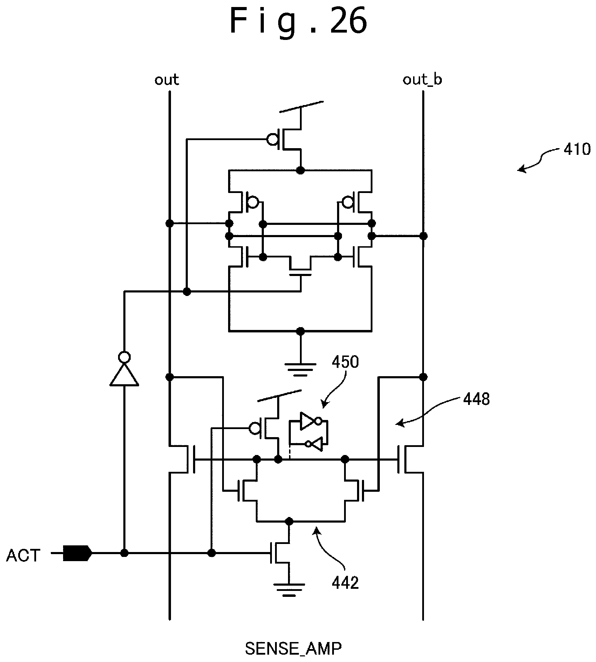

   Fig. 26 is a diagram illustrating a circuit configuration example of the sense amplifier 410 according to a modification example of the second embodiment of the present disclosure.
[Fig. 27A]

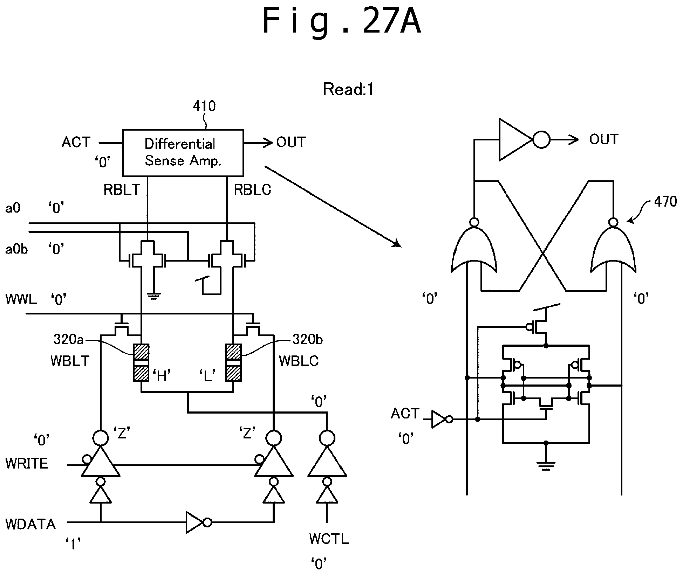

   Fig. 27A is a diagram (part 1) for explaining a read operation of the logical operation circuit 60 according to the second embodiment of the present disclosure.
[Fig. 27B]

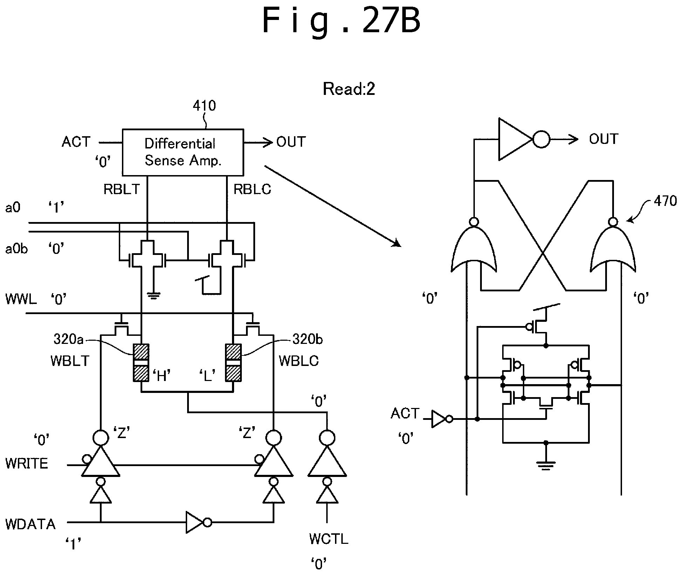

   Fig. 27B is a diagram (part 2) for explaining the read operation of the logical operation circuit 60 according to the second embodiment of the present disclosure.
[Fig. 27C]

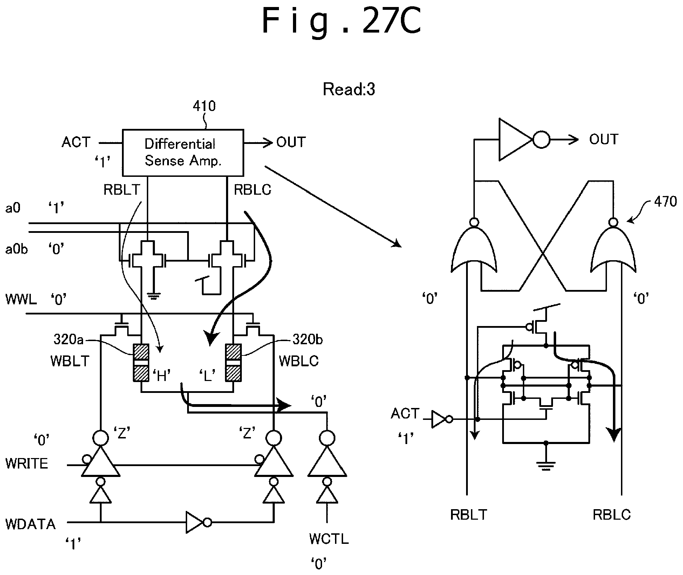

   Fig. 27C is a diagram (part 3) for explaining the read operation of the logical operation circuit 60 according to the second embodiment of the present disclosure.
[Fig. 27D]

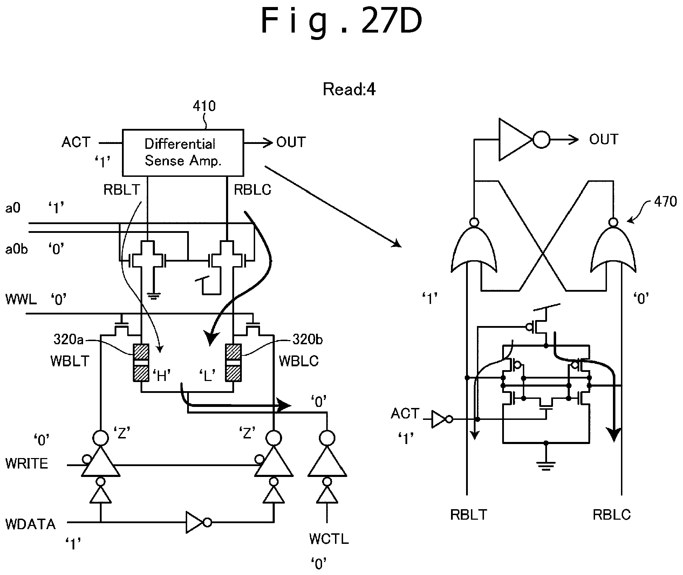

   Fig. 27D is a diagram (part 4) for explaining the read operation of the logical operation circuit 60 according to the second embodiment of the present disclosure.
[Fig. 27E]

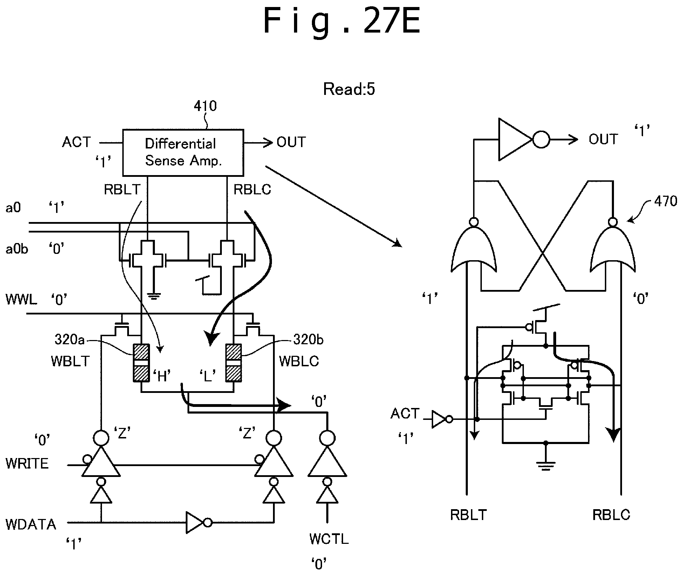

   Fig. 27E is a diagram (part 5) for explaining the read operation of the logical operation circuit 60 according to the second embodiment of the present disclosure.
[Fig. 27F]

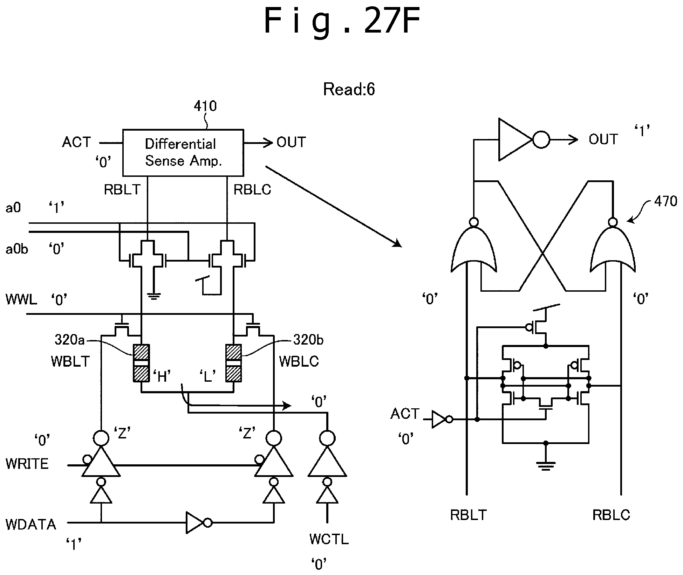

   Fig. 27F is a diagram (part 6) for explaining the read operation of the logical operation circuit 60 according to the second embodiment of the present disclosure.
[Fig. 27G]

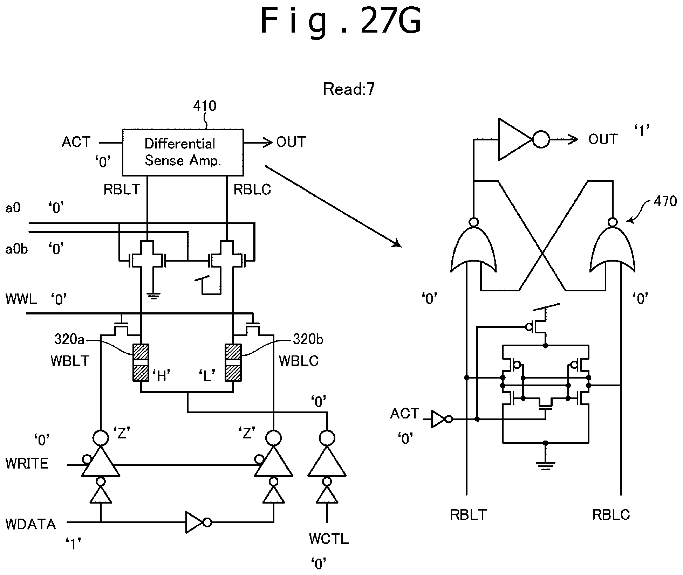

   Fig. 27G is a diagram (part 7) for explaining the read operation of the logical operation circuit 60 according to the second embodiment of the present disclosure.
[Fig. 27H]

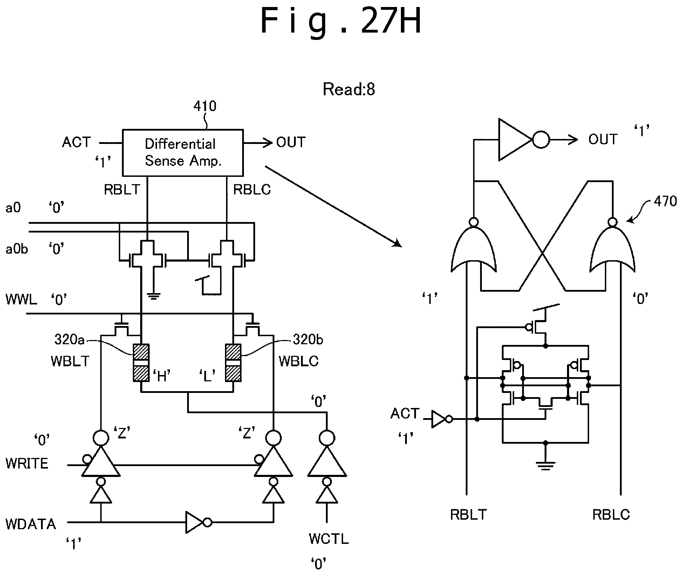

   Fig. 27H is a diagram (part 8) for explaining the read operation of the logical operation circuit 60 according to the second embodiment of the present disclosure.
[Fig. 27I]

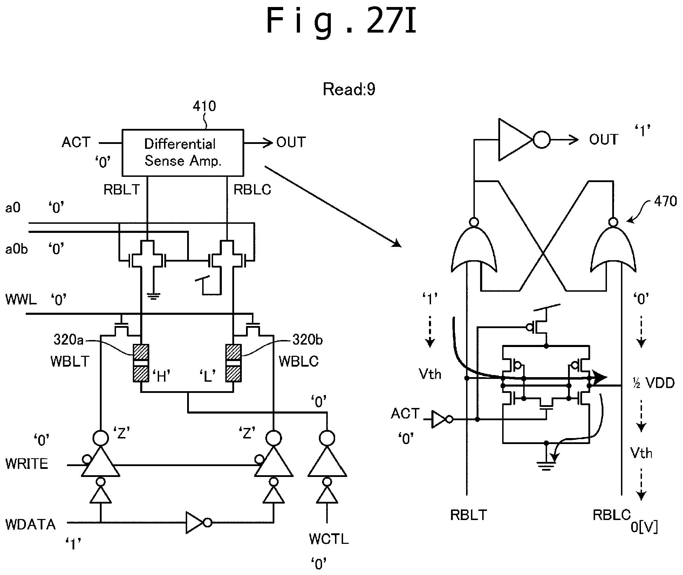

   Fig. 27I is a diagram (part 9) for explaining the read operation of the logical operation circuit 60 according to the second embodiment of the present disclosure.
[Fig. 28A]

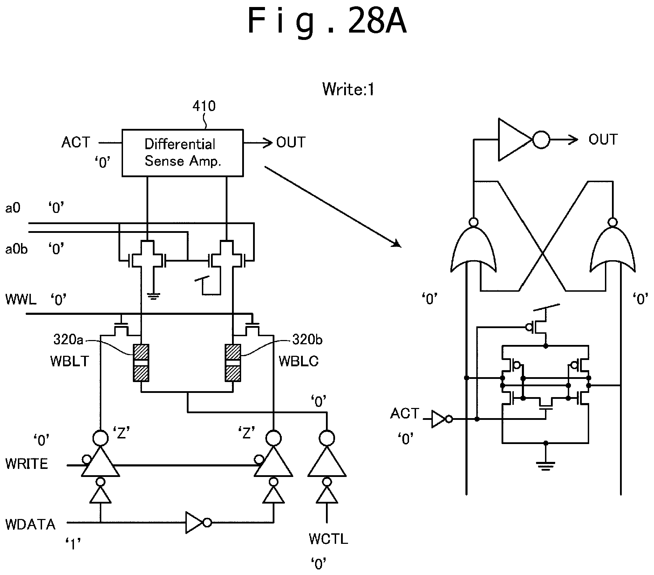

   Fig. 28A is a diagram (part 1) for explaining a write operation of the logical operation circuit 60 according to the second embodiment of the present disclosure.
[Fig. 28B]

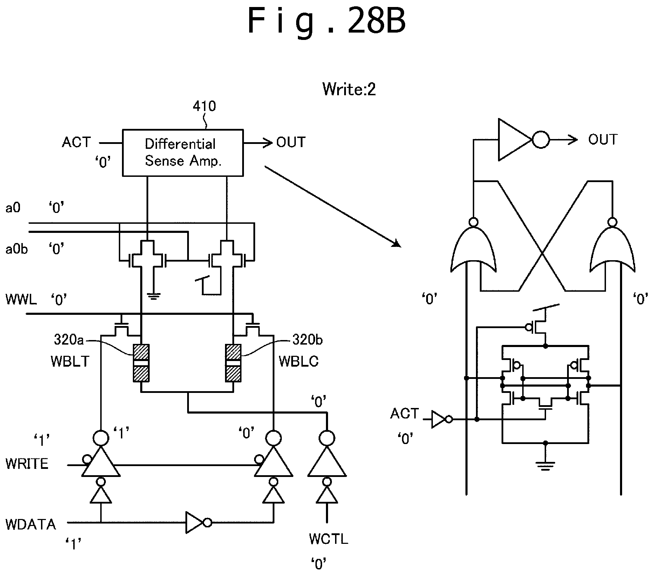

   Fig. 28B is a diagram (part 2) for explaining the write operation of the logical operation circuit 60 according to the second embodiment of the present disclosure.
[Fig. 28C]

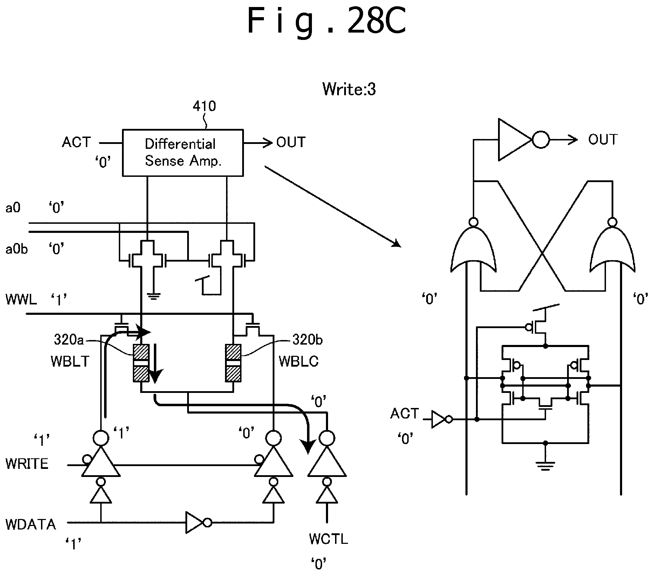

   Fig. 28C is a diagram (part 3) for explaining the write operation of the logical operation circuit 60 according to the second embodiment of the present disclosure.
[Fig. 28D]

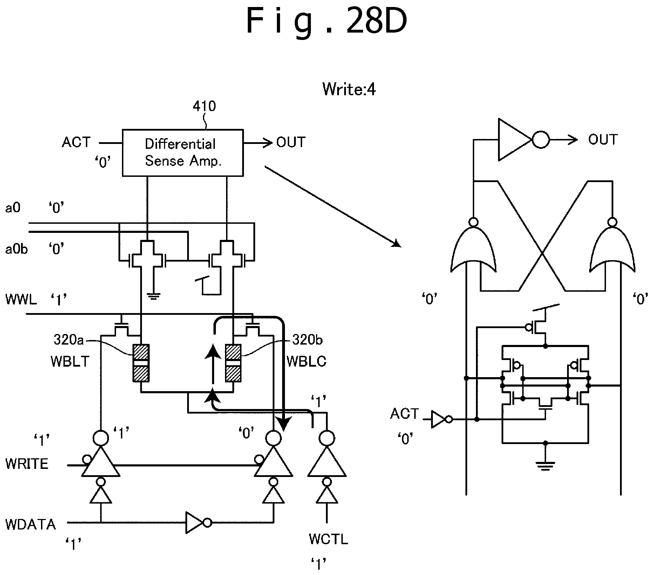

   Fig. 28D is a diagram (part 4) for explaining the write operation of the logical operation circuit 60 according to the second embodiment of the present disclosure.
[Fig. 28E]

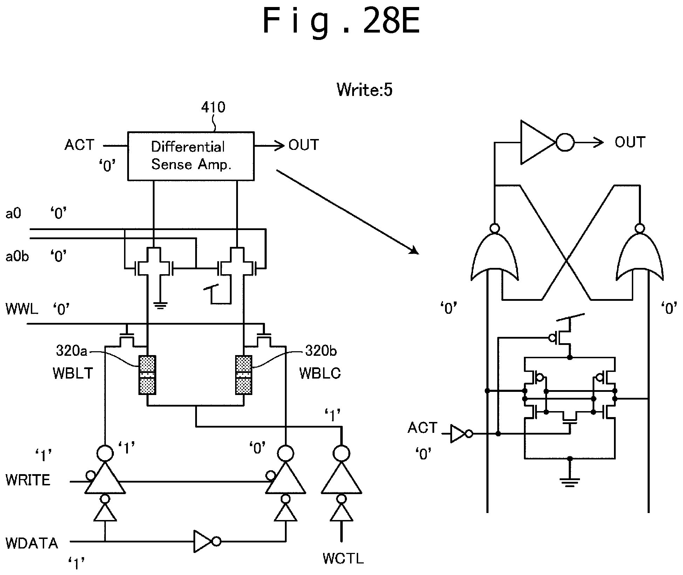

   Fig. 28E is a diagram (part 5) for explaining the write operation of the logical operation circuit 60 according to the second embodiment of the present disclosure.
[Fig. 28F]

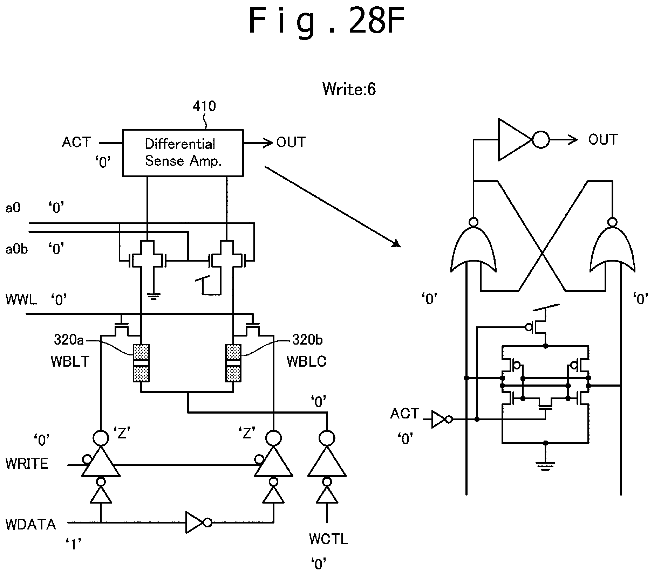

   Fig. 28F is a diagram (part 6) for explaining the write operation of the logical operation circuit 60 according to the second embodiment of the present disclosure.
[Fig. 29]

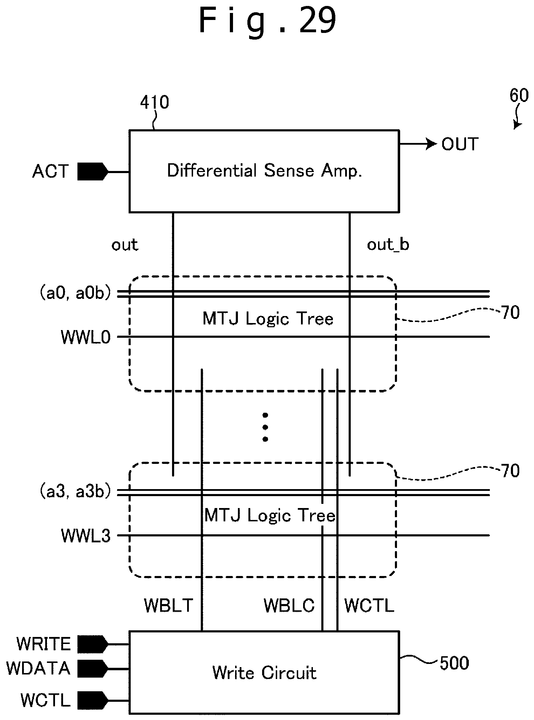

   Fig. 29 is a diagram (part 1) illustrating a configuration example of the logical operation circuit 60 according to the modification example of the second embodiment of the present disclosure.
[Fig. 30]

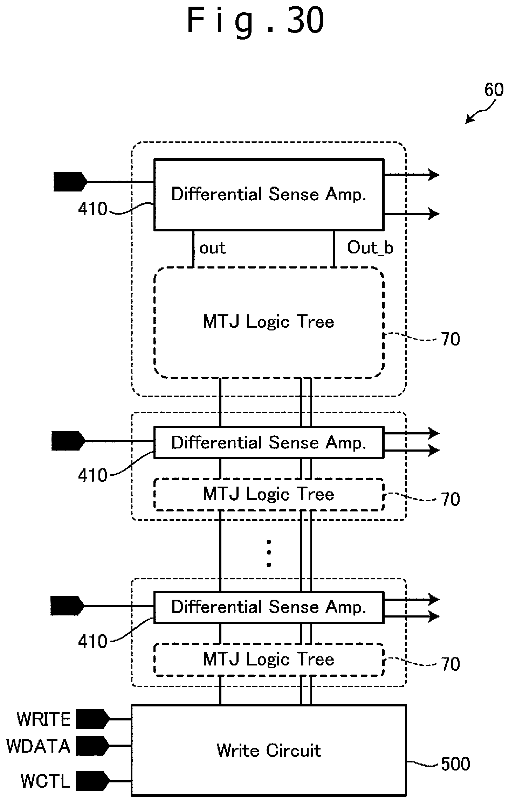

   Fig. 30 is a diagram (part 2) illustrating the configuration example of the logical operation circuit 60 according to the modification example of the second embodiment of the present disclosure.
[Fig. 31]

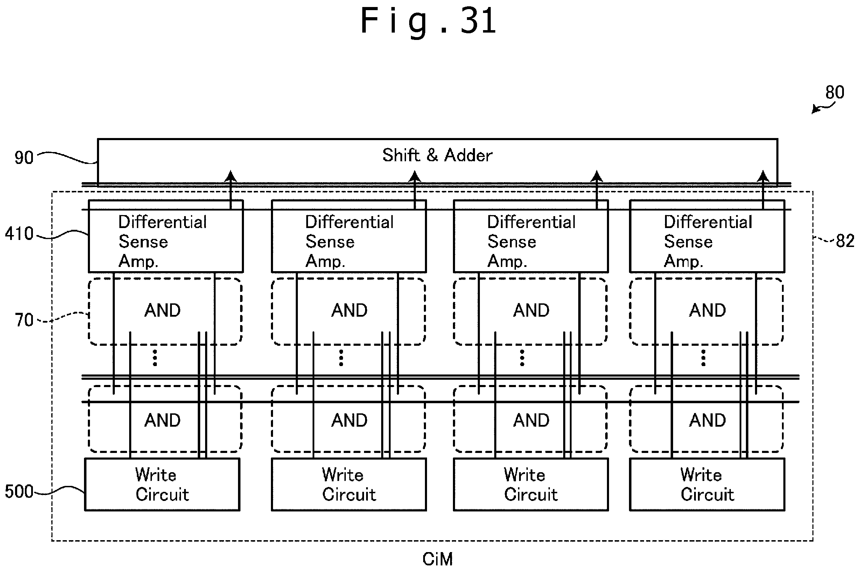

   Fig. 31 is a diagram illustrating a configuration example of a computing device CiM 80 according to a third embodiment of the present disclosure.
[Fig. 32]

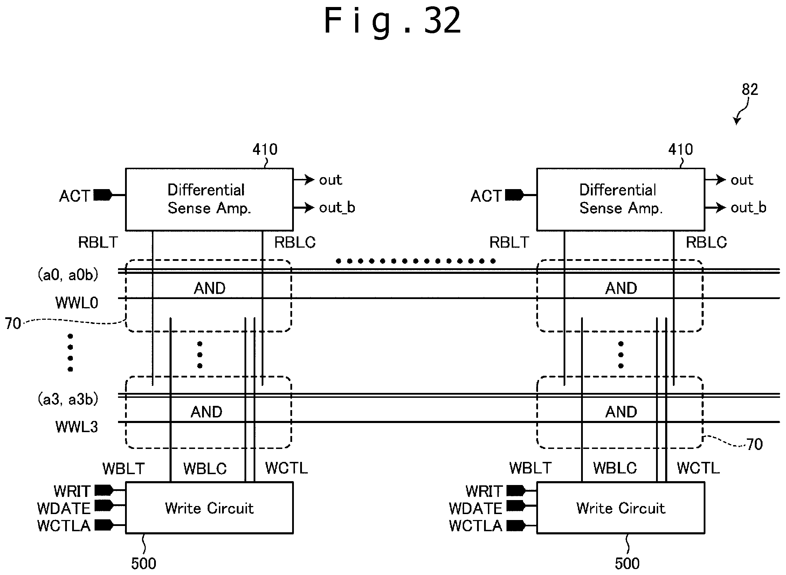

   Fig. 32 is a diagram illustrating a configuration example of main components of the CiM 80 according to the third embodiment of the present disclosure.
[Fig. 33]

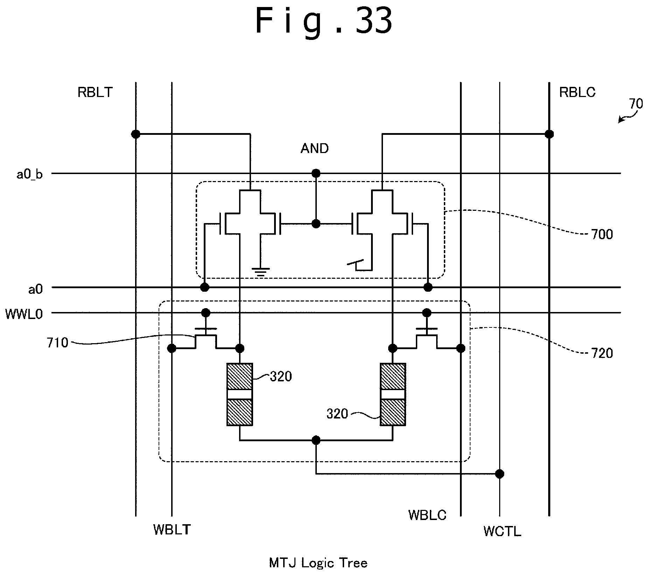

   Fig. 33 is a diagram illustrating a circuit configuration example of the differential logic tree cell 70 according to the third embodiment of the present disclosure.
[Fig. 34]

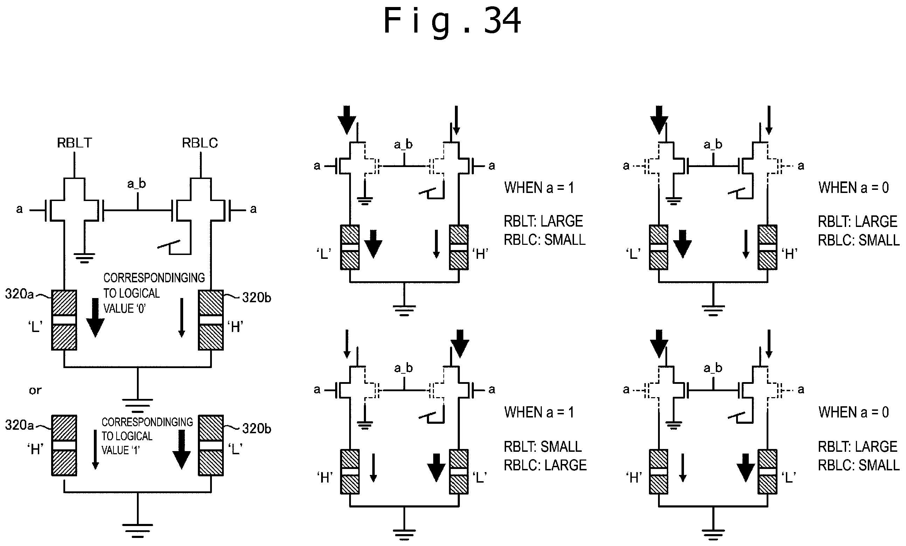

   Fig. 34 is a diagram for explaining an operation of the differential logic tree cell 70 according to the third embodiment of the present disclosure.
[Fig. 35]

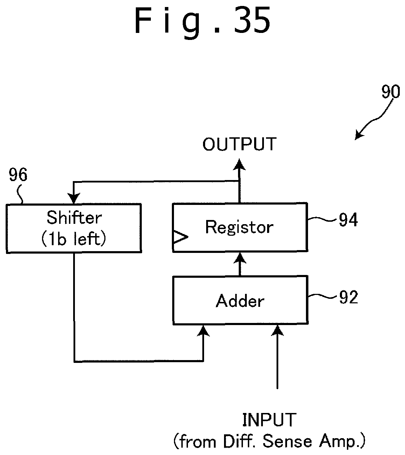

   Fig. 35 is a diagram illustrating a circuit configuration example of an adder 90 according to the third embodiment of the present disclosure.
[Fig. 36A]

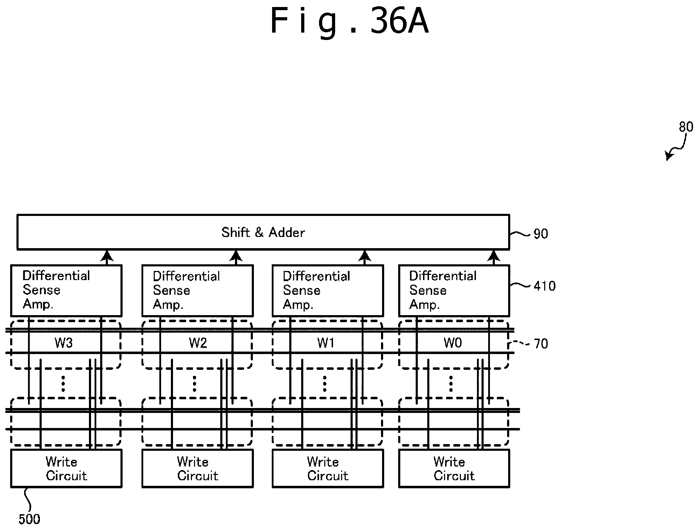

   Fig. 36A is a diagram (part 1) for explaining an operation of the CiM 80 according to the third embodiment of the present disclosure.
[Fig. 36B]

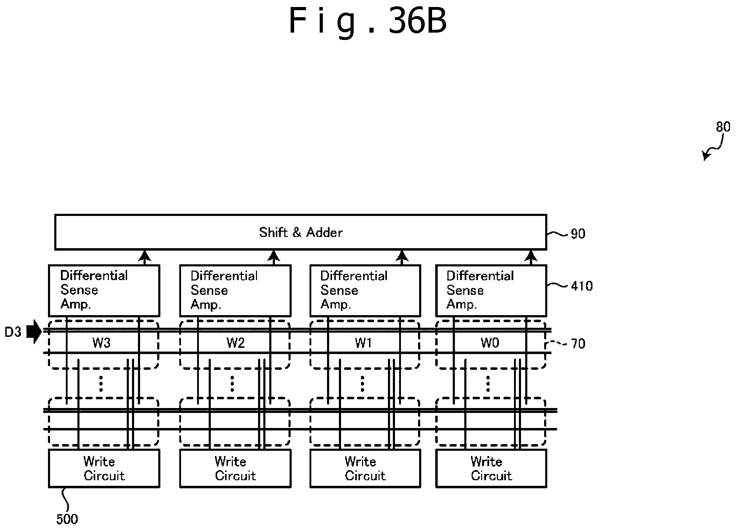

   Fig. 36B is a diagram (part 2) for explaining the operation of the CiM 80 according to the third embodiment of the present disclosure.
[Fig. 36C]

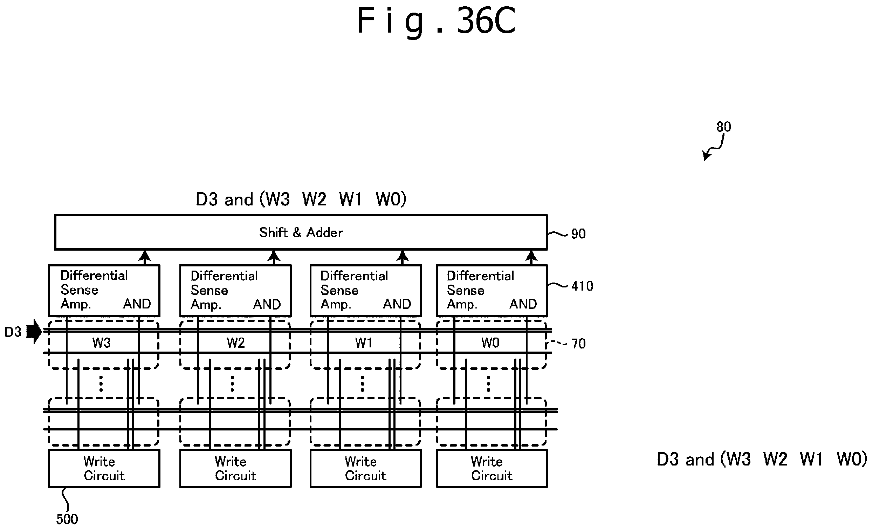

   Fig. 36C is a diagram (part 3) for explaining the operation of the CiM 80 according to the third embodiment of the present disclosure.
[Fig. 36D]

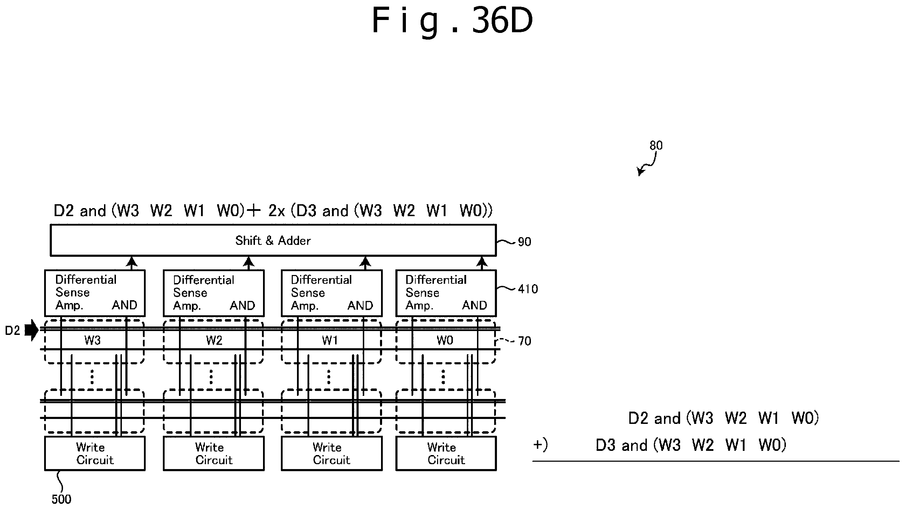

   Fig. 36D is a diagram (part 4) for explaining the operation of the CiM 80 according to the third embodiment of the present disclosure.
[Fig. 36E]

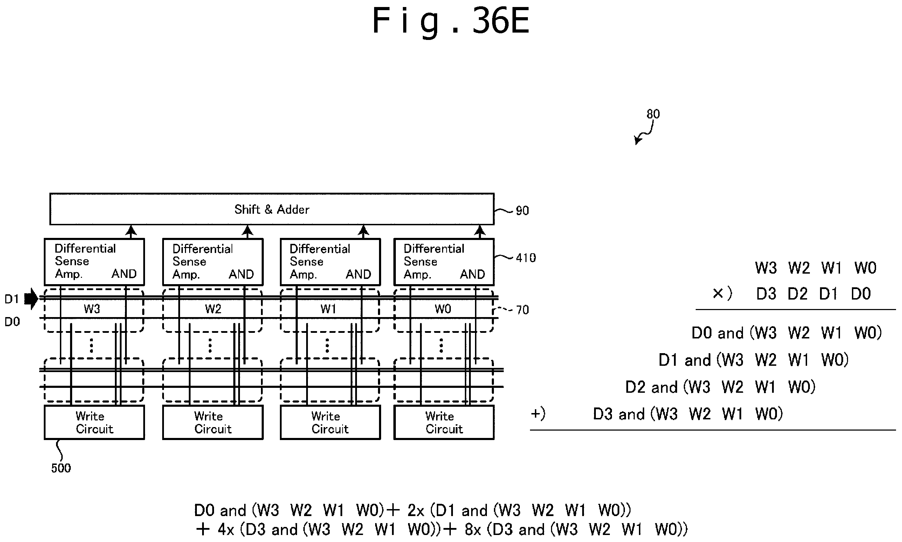

   Fig. 36E is a diagram (part 5) for explaining the operation of the CiM 80 according to the third embodiment of the present disclosure.
[Fig. 37]

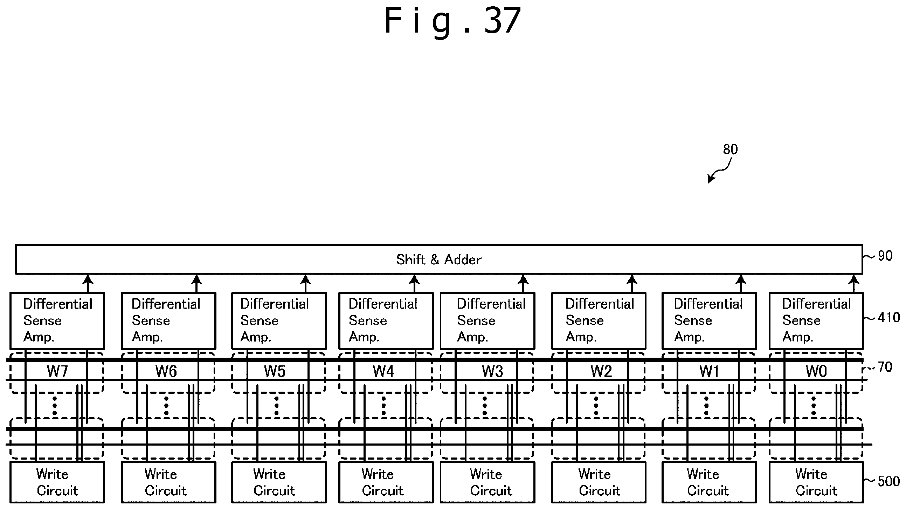

   Fig. 37 is a diagram illustrating a configuration example of the CiM 80 according to a modification example of the third embodiment of the present disclosure.
[Fig. 38]

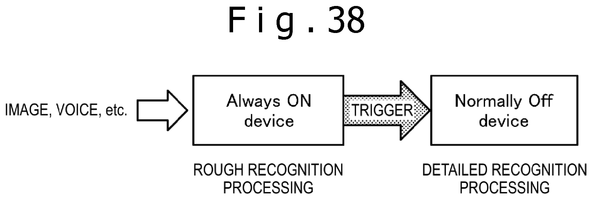

   Fig. 38 is a diagram illustrating an example of processing in electronic equipment according to the third embodiment of the present disclosure.
[Fig. 39]

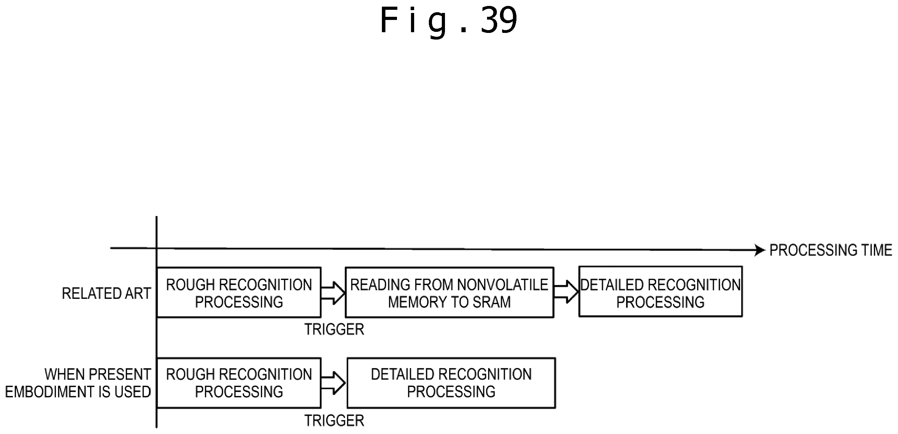

   Fig. 39 is a diagram for explaining a comparison of processing times between the third embodiment of the present disclosure and the related art.

### Description of Embodiments

Hereinafter, preferred embodiments of the present disclosure will be described in detail with reference to the accompanying drawings. Note that, in the present specification and the drawings, components having substantially the same functional configuration are denoted by the same reference numeral, and redundant description thereof will be omitted. Further, in the present specification and the drawings, a plurality of components having substantially the same functional configuration or similar functional configurations may be distinguished from each other by adding different alphabet letters after the same reference numeral. However, when it is not necessary to particularly distinguish the plurality of components having substantially the same functional configuration or similar functional configurations, only the same reference numeral is assigned.

Further, the drawings to be referred to in the following description are drawings that explain the embodiments of the present disclosure and facilitate the understanding thereof, and shapes, dimensions, and ratios illustrated in the drawings may be different from actual ones for ease of understanding. Furthermore, designs of devices illustrated in the drawings can be changed as appropriate in consideration of the following description and known techniques.

In the following description of a circuit (electrical connection), unless otherwise specified, "electrically connected" means that a plurality of elements are connected to each other so as to conduct electricity (signals). In addition, "electrically connected" in the following description includes not only a case where a plurality of elements are directly and electrically connected, but also a case where a plurality of elements are indirectly and electrically connected via another element.

Further, in the following description, "sharing" means that components different from each other (for example, an MTJ element, a differential logic tree cell, and the like) commonly use a single unit of another component (for example, a sense amplifier, a write circuit, or the like).

Hereinafter, embodiments of the present disclosure will be described in detail with reference to the drawings. Note that the description will be given in the following order.
1. First Embodiment
   1.1 Background
   1.2 Detailed Configuration
   1.3 Operation
2. Second Embodiment
   2.1 Background
   2.2 Detailed Configuration
   2.3 Operation
   2.4 Modification Example
3. Third Embodiment
   3.1 Background
   3.2 Detailed Configuration
   3.3 Operation
   3.4 Modification Example
   3.5 Application Example
4. Supplement

### 1. First Embodiment

### 1.1 Background

First, a background that led the inventors of the present disclosure to create a first embodiment of the present disclosure will be described with reference to Fig. 1. Fig. 1 is a diagram illustrating a circuit configuration example of a memory cell 310a according to the related art.

As described above, the MRAM stores data by using the fact that the electric resistance changes when the magnetization state of the magnetic material of the magnetic storage element included in the MRAM is changed. Specifically, the MRAM uses an MTJ element (magnetic storage element) 320 as a storage element. In the related art, the MRAM includes a plurality of the memory cells 310a as illustrated in Fig. 1. Each of the memory cells 310a includes one MTJ element 320 and one access transistor 330, and has a so-called 1T1R configuration. Further, each of the memory cells 310a is disposed at an intersection of a bit line and a word line. The MRAM stores data with "1" and "0" by associating the data with a high resistance state (for example, about 10 kΩ) and a low resistance state (for example, about 5 kΩ) of the MTJ element 320 included in one memory cell 310a serving as one storage unit.

When reading data from the memory cell 310a according to such related art, a difference in the potential between the voltage of the MTJ element 320 and the voltage of a reference cell (not illustrated), or a difference in the current between the current of the MTJ element 320 and the current of the reference cell is detected by a sense amplifier (not illustrated). Further, the reference cell is set to a value (an intermediate resistance value) corresponding to an intermediate state between the high resistance state and the low resistance state of the MTJ element 320, and the sense amplifier is constituted of, for example, a differential amplifier, which is an analog circuit, that amplifies the detected difference and outputs the data with "1" or "0", namely, a logical value.

Incidentally, in the MRAM according to the related art, the sense amplifier used for reading the data from each of the memory cells 310a is not provided in the vicinity of each of the memory cells 310a, but one sense amplifier is provided so as to correspond to a predetermined number of the memory cells 310a. Therefore, the lengths of the wiring lines electrically connecting the respective memory cells 310a and the reference cell are different for each of the memory cells 310a. Therefore, a parasitic resistance value, which is caused by the wiring lines having different lengths, is added to the resistance value of each of the memory cells 310a. Thus, even if the reference cell has an ideal intermediate resistance value, a margin (read margin) of the resistance value between the memory cell 310a and the reference cell becomes narrow depending on the positional relationship between the memory cell 310a and the reference cell, and it becomes difficult to read the data from the memory cell 310a with high accuracy using the sense amplifier.

Thus, it is conceivable to provide a sense amplifier corresponding to each of the memory cells 310a in the vicinity of the memory cell 310a, but this naturally results in an increase in the chip area. Such an increase in the chip area is not preferable because it makes it difficult to downsize the MRAM and it increases the manufacturing cost.

Further, in the MRAM, in general, since the resistance value of the MTJ element 320 in the high resistance state tends to be small under a high temperature environment, the above-described read margin may become narrow. Therefore, even when the sense amplifier corresponding to each of the memory cells 310a is provided in the vicinity of the memory cell 310a, it may be difficult to read the data accurately using the sense amplifier. Therefore, there is a high probability that a data reading error occurs. Thus, a redundant circuit or an error correction code (ECC) circuit is provided in the MRAM, which again makes it difficult to avoid an increase in the chip area and an increase in power consumption.

In light of the circumstances described above, the inventors of the present disclosure conceived the first embodiment of the present disclosure described below. The memory cell 310a of the related art has the 1T1R configuration, whereas the memory cell 310 (see Fig. 4) of the present embodiment has a so-called 2T2R configuration including two of the MTJ elements 320 and two of the access transistors 330. Then, in the present embodiment, a difference in the resistance value between the two MTJ elements 320 in one memory cell 310 is detected to read the data, thereby eliminating the need for the reference cell.

Specifically, in the present embodiment, the data with "1" is stored by setting one of the MTJ elements 320, of the one memory cell 310 serving as one storage unit, to the high resistance state, and setting the other MTJ element 320 to the low resistance state. Furthermore, in the present embodiment, the data with "0" is stored by setting the one MTJ element 320 of the one memory cell 310 to the low resistance state, and setting the other MTJ element 320 to the high resistance state. In the related art, the data is read by detecting a difference in the resistance value between the one MTJ element 320 in the one memory cell 310 and the reference cell. On the other hand, in the present embodiment, the data is read by detecting a difference in the resistance value between the two MTJ elements 320 in the one memory cell 310. In the present embodiment, since a difference between the MTJ element 320 in the high resistance state and the MTJ element 320 in the low resistance state is detected, the amount of difference naturally becomes large. Therefore, in the present embodiment, reading of the amount of difference becomes easier than in the related art, and it is thus possible to read the data with high accuracy. Therefore, the probability of the occurrence of the reading error is low, and it is thus not necessary to provide a redundant circuit or an error correction circuit in the MRAM 10. As a result, according to the present embodiment, it is possible to avoid an increase in the chip area and an increase in the power consumption. Furthermore, in the present embodiment, unlike the related art, it is not necessary to provide the reference cell. Further, in the present embodiment, the memory cell 310 having such a configuration is used in combination with a suitable sense amplifier 410 (see Fig. 9).

That is, according to the present embodiment, it is possible to provide the MRAM (storage device) 10 capable of accurately reading the data while avoiding an increase in the chip area. Details of the first embodiment of the present disclosure will be described below in order.

### 1.2 Detailed Configuration

### MRAM 10

First, with reference to Fig. 2, an overall configuration of the MRAM (storage device) 10 according to the first embodiment of the present disclosure will be described. Fig. 2 is a diagram illustrating a configuration example of the MRAM 10 according to the present embodiment.

As illustrated in Fig. 2, the MRAM 10 according to the present embodiment mainly includes a word line driver 20, a memory cell array 30, and a peripheral circuit unit 40 that includes a read circuit 400 and a write circuit 500. Further, the memory cell array 30 includes a plurality of the memory cells 310 arrayed in a matrix along a row direction and a column direction. Furthermore, the memory cells 310 located in the same row are electrically connected to the same word line (WL00 to WL0F), and the memory cells 310 located in the same column are electrically connected to the same bit line (BLT, BLC). The plurality of memory cells 310 in the memory cell array 30 will be described below using an example in which the memory cells 310 are arrayed in 16 rows and 16 columns, but the arrangement is not limited thereto in the present embodiment. Details of each of components constituting the MRAM 10 according to the present embodiment will be described below in order.

### Word Line Driver 20

First, with reference to Fig. 3, a configuration of the word line driver 20 according to the present embodiment will be described. Fig. 3 is a diagram illustrating a circuit configuration example of the word line driver 20 according to the present embodiment.

Here, as described above, it is assumed that the plurality of memory cells 310 in the memory cell array 30 are arrayed in 16 rows and 16 columns. Therefore, the word line driver 20 receives 4 bytes of address data (D3, D2, D1, D0), and a detect signal from the read circuit 400 which will be described later. Further, the word line driver 20 outputs decode signals to the 16 word lines (WL00 to WL0F).

Specifically, as illustrated in Fig. 3, the word line driver 20 includes a known address decoder 202, an inverter 204, and 16 pairs of a NAND circuit 210 and an inverter 212. The address decoder 202 exclusively sets the decode signals corresponding to 16 addresses (adrs00 to adrs0F) to "1" in accordance with the input of the 4-byte address, and outputs the decode signals to the above-described pairs. Then, the NAND circuit 210 performs a logical operation between the signal from the address decoder 202 and the detect signal inverted by the inverter 204, and after inversion by the inverter 212, the NAND circuit 210 exclusively outputs the decode signal of "1" to any one of the 16 word lines (WL00 to WL0F). When the detect signal is "0", the decode signals of "0" are forcibly output to the 16 word lines (WL00 to WL0F). In the present embodiment, in this way, the word line driver 20 can select a word line to be controlled.

### Memory Cell Array 30

Next, a configuration of the memory cell array 30 according to the present embodiment will be described with reference to Figs. 4 to 6. Fig. 4 is a diagram illustrating a circuit configuration example of the memory cell 310 according to the present embodiment, and Fig. 5 is a diagram for explaining an operation of the memory cell 310 according to the present embodiment. Further, Fig. 6 is a diagram illustrating a configuration example of the memory cell array 30 according to the present embodiment.

As illustrated on the left side of Fig. 4, the memory cell 310 according to the present embodiment includes two of the MTJ elements (first and second magnetic storage elements) 320 and the access transistors (first and second access transistors) 330 electrically connected to the two MTJ elements 320, respectively. That is, the memory cell 310 according to the present embodiment has the 2T2R configuration, and in the following description, the memory cell 310 may also be referred to as a "twin cell".

Specifically, one of the terminals (first terminal) of the MTJ element 320 is electrically connected to one of the source and the drain (first terminals) of the access transistor 330. The other terminal (second terminal) of the MTJ element 320 is electrically connected to a WCTL/AGND line) (common reference potential line) extending in the column direction. The WCTL/AGND line corresponds to a ground line of the memory cell 310. Further, the other of the source and the drain (second terminal) of the access transistor 330 is electrically connected to one of an ABLT line and an ABLC line (first and second bit lines), which are bit lines extending in the column direction. The ABLT line and the ABLC line have opposite polarities from each other. The gate (third terminal) of the access transistor 330 is electrically connected to the word line extending in the row direction. The access transistor 330 is constituted of, for example, an n-type metal oxide semiconductor (MOS) transistor, and connects the MTJ element 320 to the ABLT line or the ABLC line when the word line connected to the gate of the access transistor 330 is set to "1".

Further, the MTJ element 320 has a stacked structure as illustrated on the right side of Fig. 4. Specifically, the MTJ element 320 has a structure in which a fixed layer 326 in which the magnetic moment (magnetization direction) is fixed to a predetermined direction, a nonmagnetic layer 324, a free layer 322 in which the direction of the magnetic moment is variable, and a cap layer (not illustrated) are sequentially stacked on an underlayer (not illustrated). That is, the nonmagnetic layer 324 is sandwiched between the fixed layer 326 and the free layer 322. Note that, in the present embodiment, the same layers of the two MTJ elements 320 in the one memory cell 310 may be electrically connected to the access transistor 330 and the WCTL/AGND line, and the order of stacking need not necessarily be the order illustrated on the right side of Fig. 4.

The fixed layer 326 is formed by a magnetic material including a ferromagnetic material, and the direction of the magnetic moment thereof is fixed by a high coercive force or the like. The nonmagnetic layer 324 is formed by various nonmagnetic materials such as magnesium oxide (MgO), and the like. The free layer 322 is formed by a magnetic material including a ferromagnetic material, and the direction of the magnetic moment thereof changes in accordance with information to be stored therein. Further, the underlayer and the cap layer function as an electrode, a control film of crystal orientation, a protective film, and the like. In the MTJ element 320, by applying a voltage to the MTJ element 320 and changing the direction of the magnetic moment of the free layer 322, the overall resistance value of the MTJ element 320 changes due to a difference in the direction of the magnetic moment between the fixed layer 326 and the free layer 322. Specifically, when the directions of the magnetic moments of the fixed layer 326 and the free layer 322 are the same, the resistance value of the MTJ element 320 becomes low (low resistance state), and when the directions of the magnetic moments of the fixed layer 326 and the free layer 322 are different from each other, the resistance value of the MTJ element 320 becomes high (high resistance state). The MTJ element 320 can store data by using such a change in the resistance value, which is caused by the change in the magnetic moment.

Further, in the present embodiment, as illustrated in Fig. 5, data is stored in one memory cell 310 serving as one storage unit. Specifically, as illustrated on the left side of Fig. 5, the memory cell 310 stores data with a logical value of "0" by setting one of the MTJ elements 320a to the low resistance state (L) and setting the other MTJ element 320b to the high resistance state (H). Furthermore, in the present embodiment, as illustrated on the right side of Fig. 5, the memory cell 310 stores data with a logical value of "1" by setting the one MTJ element 320a to the high resistance state (H) and setting the other MTJ element 320b to the low resistance state (L). Note that, in the present embodiment, the logical value of "0" and the logical value of "1" need not necessarily be stored as illustrated in Fig. 5. In the present embodiment, for example, the memory cell 310 may store the data with the logical value of "1" by setting the one MTJ element 320a to the low resistance state (L) and setting the other MTJ element 320b to the high resistance state (H), and the memory cell 310 may store the data with the logical value of "0" by setting the one MTJ element 320a to the high resistance state (H) and setting the other MTJ element 320b to the low resistance state (L).

In the present embodiment, since the difference between the MTJ element 320 in the high resistance state and the MTJ element 320 in the low resistance state in one memory cell 310, which serves as one storage unit, is detected, the amount of difference becomes large. Therefore, in the present embodiment, reading of the amount of difference becomes easier than in the related art, and it is thus possible to read the data with high accuracy. As a result, according to the present embodiment, the probability of the occurrence of the reading error is low, and it is thus not necessary to provide a redundant circuit or an error correction circuit (ECC) in the MRAM 10. Therefore, according to the present embodiment, it is possible to avoid an increase in the chip area and an increase in the power consumption. Further, in the present embodiment, since the amount of difference to be read is large, the operation can be performed at a higher speed if the power supply voltage is the same, and the operation can be performed at a lower power supply voltage if the operation speed is the same. In addition, according to the present embodiment, unlike the related art, it is not necessary to provide the reference cell.

Further, as illustrated in Fig. 6, the memory cell array 30 includes the plurality of memory cells 310 arrayed in a matrix along the row direction and the column direction. As described above, the plurality of memory cells 310 located in the same row are electrically connected to the same word line (WL00 to WL0F), and the plurality of memory cells 310 located in the same column are electrically connected to the same ABLT line and ABLC line (bit lines) and the same AGND line (ground line).

### Multiplexer Circuit 350

Next, a configuration of a multiplexer circuit (Multiplexer; MUX) 350 according to the present embodiment will be described with reference to Fig. 7. Fig. 7 is a diagram illustrating a configuration example of the multiplexer circuit 350 according to the present embodiment.

The multiplexer circuit 350 is provided between the memory cell array 30 and the peripheral circuit unit 40 that includes the read circuit 400 and the write circuit 500, and inputs data to one of the memory cells 310 selected from the plurality of memory cells 310, or outputs data from the selected one of the memory cells 310. Specifically, in the present embodiment, the multiplexer circuit 350 is constituted of three multiplexer circuits corresponding to the ABLT line, the ABLC line, and the AGND line, respectively. Each of the multiplexer circuits 350 includes a transmission gate 352 connected to each of, for example, 16 lines extending from the memory cell array 30. That is, one of the multiplexer circuits (first multiplexer circuit) 350 is electrically connected to 16 of the ABLT lines (first bit lines), another of the multiplexer circuits (second multiplexer circuit) 350 is electrically connected to 16 of the ABLC lines (second bit lines), and still another of the multiplexer circuits (third multiplexer circuit) 350 is electrically connected to 16 of the AGND lines (common reference potential lines). Then, each of the multiplexer circuits 350 exclusively selects one of the 16 lines, and connects the selected line to the BLT line and the BLC line of the peripheral circuit unit 40. The BLT line corresponds to the ABLT line, the BLC line corresponds to the ABLC line, and the BLT line and the BLC line have opposite polarities from each other.

### Read Circuit 400

Next, a configuration of the read circuit 400 according to the present embodiment will be described with reference to Figs. 8 to 10. Fig. 8 is a diagram illustrating a configuration example of the read circuit 400 according to the present embodiment. Further, Fig. 9 is a diagram illustrating a circuit configuration example of the sense amplifier 410 according to the present embodiment, and Fig. 10 is a diagram illustrating a circuit configuration example of a detector circuit 440 according to the present embodiment.

The read circuit 400 according to the present embodiment is a circuit that reads the difference in the resistance value between the two MTJ elements 320, and specifically, can read the difference in the resistance value or a ratio of the resistance values between the two MTJ elements 320. As illustrated in Fig. 8, the read circuit 400 according to the present embodiment includes the digital differential sense amplifier 410 electrically connected to the memory cell array 30, the detector circuit (shutoff circuit) 440 electrically connected to the sense amplifier 410, and a NOR-type RS latch circuit 470 electrically connected to the detector circuit 440. In the present embodiment, the BLT line and the BLC line from the memory cell array 30 are connected to the sense amplifier 410, the detector circuit 440, and the NOR-type RS latch circuit 470.

In the present embodiment, the digital differential sense amplifier 410 is used that is suitable for the configuration of the memory cell 310 described above. As illustrated in Fig. 9, the sense amplifier 410 includes two inverters 420 including input and output terminals that are connected to each other in a loop, an n-type MOS transistor (first switch) 414 that electrically connects the output terminals of the two inverters 420 to each other, and a p-type MOS transistor (second switch) 412 that electrically connects the two inverters 420 to the power supply. Further, the sense amplifier 410 includes a NOR circuit 418 electrically connected to the gate of the n-type MOS transistor 414, and an inverter 416 electrically connected to the gate of the p-type MOS transistor 412.

Specifically, each of the inverters 420 is constituted of electrically connecting the source of the p-type MOS transistor to a power supply line, electrically connecting the sources of the p-type MOS transistor and the n-type MOS transistor to each other, electrically connecting the gates of the p-type MOS transistor and the n-type MOS transistor to each other, and grounding the source of the n-type MOS transistor. Then, the input of the inverter 420 becomes a node at which the gates of the p-type MOS transistor and the n-type MOS transistor are connected to each other, and the output of the inverter 420 becomes a node at which the sources of the p-type MOS transistor and the n-type MOS transistor are connected to each other. In the present embodiment, the two inverters 420 are connected to each other in a loop. Further, the n-type MOS transistor 414 can switch electrical connection between the output terminals of the two inverters 420. Further, the p-type MOS transistor 412 can switch electrical connection between the two inverters 420 and the power supply. Then, the switching operations of the two transistors 412 and 414 are controlled by an activation (ACT) signal and a write (WRITE) signal.

Specifically, when the ACT signal is "0", the sense amplifier 410 is in an inactive initial state. At this time, the n-type MOS transistor 414 short-circuits the output terminals of the two inverters 420, and thus, the BLT line and the BLC line are short-circuited and have the same potential (for example, a potential from 0 V to about a threshold value Vth of the n-type MOS transistor 414).

Then, when reading is performed, the ACT signal is set to "1". In this way, the short-circuit of the output terminals of the two inverters 420 by the n-type MOS transistor 414 is eliminated, and at the same time, the looped two inverters 420 start to operate and function as the sense amplifier 410. Then, one of the BLT line and the BLC line is connected to the AGND line (ground line) at a high resistance by the MTJ element 320 that is in the high resistance state, and the other of the BLT line and the BLC line is connected to the AGND line (ground line) at a low resistance by the MTJ element 320 that is in the low resistance state. Therefore, a difference is generated in the magnitudes of two currents flowing out from the sense amplifier 410 to the BLT line and the BLC line, respectively, and the potential of the output on the high resistance side of the two outputs of the sense amplifier 410 quickly rises and quickly reaches the potential corresponding to the logical value of "1". In this way, the sense amplifier 410 can quickly read the data stored in the memory cell 310. Therefore, the MRAM 10 according to the present embodiment can operate at a higher speed than the related art if the voltage is the same. Then, the data read out to the sense amplifier 410 is temporarily held in the NOR-type RS latch circuit 470, and is output to an output OUT_T and an output OUT_C (see Fig. 8) of the MRAM 10. Note that the output OUT_T and the output OUT_C have opposite polarities from each other.

Further, in the present embodiment, as illustrated in Fig. 10, the detector circuit 440 includes a dynamic NOR logic circuit 442 electrically connected to the sense amplifier 410 and including two input terminals, and a NAND circuit (NAND logic circuit) 444 electrically connected to the dynamic NOR logic circuit 442. The detector circuit 440 can output a DETECT signal to the above-described word line driver 20. The detector circuit 440 can cut off the current from the sense amplifier 410 to the MTJ element 320 by outputting a predetermined DETECT signal to the word line driver 20.

Specifically, the dynamic circuit has a function of temporarily holding data at a common output node (dynamic node) by utilizing the parasitic capacitance generated in the circuit. The dynamic NOR logic circuit 442 includes two n-type transistors whose gates as inputs are electrically connected to the BLT line and the BLC line, respectively, as illustrated in Fig. 10. The drains of these transistors are electrically connected to the dynamic node and are connected to the power supply via a p-type MOS transistor 446. Further, the sources of the two transistors of the dynamic NOR logic circuit 442 are grounded (connected to the ground) via an n-type MOS transistor 445. Then, the operations of the p-type MOS transistor 446 and the n-type MOS transistor 445 are controlled by the ACT signal. Furthermore, the common output node of the dynamic NOR logic circuit 442 is electrically connected to the NAND circuit 444. The NAND circuit 444 receives not only a signal from the dynamic NOR logic circuit 442 but also a write word line control signal (WWL signal), and outputs the operation result of these two input signals to the word line driver 20 as the DETECT signal.

Specifically, when the ACT signal is "0", the detector circuit 440 is in an inactive initial state. At this time, as described above, the BLT line and the BLC line are short-circuited to have the same potential in the vicinity of 0 V. Further, at this time, since the common output node of the dynamic NOR logic circuit 442 is initialized to "1" by the p-type MOS transistor 446, the output (DETECT signal) of the detector circuit 440 is inverted by the NAND circuit 444 and becomes "0".

Then, when reading is performed, the ACT signal is set to "1". The WWL signal is a signal controlled at the time of writing and is always set to "1" at the time of reading. In this way, as described above, one of the BLT line and the BLC line has the logical value of "1" and the other of the BLT line and the BLC line has the logical value of "0" in accordance with the state (the high resistance state or the low resistance state) of the MTJ element 320, and thus the common output node of the dynamic NOR logic circuit 442 has the logical value of "0". Then, the logical value of "0" is inverted by the NAND circuit 444, and thus the output (DETECT signal) of the detector circuit 440 becomes "1". Then, the DETECT signal of "1" is input to the word line driver 20, whereby a signal of "0" is input to the word line. As a result, the access transistor 330 electrically connected to the MTJ element 320, from which the data has been read up to this point in time, is turned off, and the current from the sense amplifier 410 to the MTJ element 320 is cut off. That is, in the present embodiment, with such a configuration, when the reading of data is completed, the word line is immediately and autonomously set to "0", and the access transistor 330 corresponding to the MTJ element 320 from which the data has been read can be quickly turned off. As a result, in the present embodiment, the current flowing from the sense amplifier 410 to the MTJ element 320 can be suppressed to the minimum necessary, and thus, the power consumption of the MRAM 10 can be reduced and the reliability can be improved. Note that details of the read operation according to the present embodiment will be described later.

Note that the potential of the common output node of the dynamic NOR logic circuit 442, which is supposed to be held, is changed by a leakage current, and thus, there is a possibility that an erroneous data is output from the dynamic NOR logic circuit 442 and the MRAM 10 malfunctions. Therefore, as illustrated in Fig. 10, in order to stably hold the potential of the common output node of the dynamic NOR logic circuit 442, an inverter loop 450 constituted of two inverters including input and output terminals connected to each other in a loop may be added to the common output node.

### Write Circuit 500

Next, a configuration of the write circuit 500 according to the present embodiment will be described with reference to Fig. 11. Fig. 11 is a diagram illustrating a circuit configuration example of the write circuit 500 according to the present embodiment.

In the present embodiment, the write circuit 500 writes the logical value of "1" (first value) to the memory cell 310 by applying a voltage so that a current flows from one terminal (first terminal) to the other terminal (second terminal) of one of the MTJ elements (first magnetic storage element) 320 of one memory cell 310, and applying a voltage so that a current flows from the other terminal to the one terminal of the other MTJ element (second magnetic storage element) 320 of the memory cell 310. Further, in the present embodiment, the write circuit 500 writes the logical value of "0" (second value) to the memory cell 310 by applying a voltage so that a current flows from the other terminal to the one terminal of the one MTJ element 320, and applying a voltage so that a current flows from the one terminal to the other terminal of the other MTJ element 320.

Specifically, in the present embodiment, as illustrated in Fig. 11, the write circuit 500 includes two tri-state buffers 502 electrically connected to the BLT line and the BLC line (first and second bit lines), respectively, and an inverter (common reference potential line control circuit) 504 electrically connected to a VGAD line (ground line) (common reference potential line). Further, the tri-state buffer 502 can not only switch the output of the input signal ("1" or "0") but also switch the output to a high impedance state ("Z"). That is, the tri-state buffer 502 can be switched between three states.

Specifically, at the time of reading, the two tri-state buffers 502 are controlled by the WRITE signal of "0" and brought into the high impedance state. On the other hand, at the time of writing, the two tri-state buffers 502 are controlled by the WRITE signal of "1" and output signals. Then, when "0" is written to the memory cell 310 (write data (WDATA) signal = 0), the tri-state buffer 502 on the BLT line side becomes "0", and the tri-state buffer 502 on the BLC line side becomes "1". Further, when "1" is written to the memory cell 310 (WDATA signal = 1), the tri-state buffer 502 on the BLT line side becomes "1" and the tri-state buffer 502 on the BLC line side becomes "0".

Furthermore, after the BLT line and the BCL line, which are bit lines, are set to the above-described states by the two tri-state buffers 502, respectively, the write control line (WCTL line) is switched from "0" to "1" and further from "1" to "0", whereby the potential of the VGND line of the memory cell 310 is switched via the inverter 504. Then, when the switching is performed, the direction of the current flowing through the MTJ element 320 on the bit line side, which is in the state of "0", becomes opposite to the direction of the current flowing through the MTJ element 320 on the bit line side, which is in the state of "1". Therefore, when the directions of the currents flowing through the two MTJ elements 320 are opposite to each other, the directions of the magnetic moments of the free layers 322 of the MTJ elements 320 become opposite to each other, and as a result, a difference in the resistance values is generated between the two MTJ elements 320. Note that details of the write operation according to the present embodiment will be described later.

Note that, in the embodiment of the present disclosure, the MRAM 10 is not limited to the mode illustrated in Figs. 2 to 11 and can be modified to various modes.

### 1.3 Operation

### Read Operation

Next, an example of the read operation of the MRAM 10 according to the present embodiment will be described with reference to Figs. 12A to 12G. Figs. 12A to 12G are diagrams for explaining the read operation of the MRAM 10 according to the present embodiment, and illustrate the states of respective signals and nodes as time passes. Specifically, from the top of each of the diagrams, the address signal, the state of the ABLT line [0], the state of the ABLC line [0], the state of the word line [00], the ACT signal, the DETECT signal, and the output signal (OUT_T) of the MRAM 10 are illustrated.

First, the operation of the MRAM 10 is started from an initial state illustrated at the left end of Fig. 12A. Specific states of the respective signals and nodes at this point in time are described on the right side of Fig. 12A. Then, as illustrated in Fig. 12B, a read address is input to the MRAM 10 (address "0000" is input). Then, as illustrated in Fig. 12C, the word line [00] rises to "1" in accordance with the input read address. Note that, at this time, the word lines other than the word line [00] are maintained at "0".

Then, if nothing is done, the state of Fig. 12C is maintained. When the ACT signal is set to "1", as illustrated in Fig. 12D, the reading is started, and one of the ABLT [0] line and the ABLC [0] line becomes "1". The other of the ABLT [0] line and the ABLC [0] line returns to "0" although the state thereof slightly changes.

Subsequently, when either one of the ABLT [0] line and the ABLC [0] line becomes "1", the DETECT signal becomes "1" as illustrated in Fig. 12E. At the same time, the output OUT_T, which is the output of the MRAM 10, also changes. In this way, the sense amplifier 410 according to the present embodiment can quickly read the data stored in the memory cell 310. Therefore, the MRAM 10 according to the present embodiment can operate at a higher speed than the related art if the voltage is the same, and can operate at a lower voltage if the operation speed is the same.

Then, as illustrated in Fig. 12F, since the DETECT signal has become "1", the word line [00] becomes "0". As a result, the access transistor 330 connected to the word line [00] is turned off, and thus no current flows through the MTJ element 320 electrically connected to the access transistor 330. That is, in the present embodiment, when the data reading is completed, the word line [00] is immediately and autonomously set to "0", and the access transistor 330 corresponding to the MTJ element 320, from which the data has been read, can be quickly turned off. Further, as illustrated in Fig. 12F, in the present embodiment, the NOR-type RS latch circuit 470 maintains the data to be output to the readout output OUT_T.

Although there is no particular problem even if this state is held as it is, the ACT signal is set to "0" as illustrated in Fig. 12G in preparation for the next reading. When the ACT signal is set to "0", the sense amplifier 410 is deactivated, the ABLT [0] line and the ABLC line [0] are short-circuited, and the potentials of the ABLT [0] line and the ABLC line [0] are lowered to half of the power supply potential (VDD/2). Further, the potentials of the ABLT [0] line and the ABLC [0] line are lowered to the vicinity of the threshold value (Vth) of the n-type MOS transistor 414, and then reach 0 V due to a leakage current. In this way, the MRAM 10 returns to the initial state. Further, when the ACT signal becomes "0", the detector circuit 440 also returns to the initial state.

### Write Operation

Next, an example of the write operation of the MRAM 10 according to the present embodiment will be described with reference to Figs. 13A to 13J. Figs. 13A to 13J are diagrams for explaining the write operation of MRAM 10 according to the present embodiment, and illustrate the states of respective signals and nodes as time passes. Specifically, from the top of each of the diagrams, the address signal, the WDATA signal, the WRITE signal, the states of the ABLT line and the ABLC line, the write word line control signal (WWL signal) at the time of writing, the state of the word line [00] corresponding to the memory cell 310 to be written, and the state of the write control (WCLT) line are illustrated.

First, the operation of the MRAM 10 is started from an initial state illustrated at the left end of Fig. 13A. Specific states of the respective signals and nodes at this point in time are described on the right side of Fig. 13A. The ACT signal controlled at the time of reading is fixed to "0" at the time of writing. Then, as illustrated in Fig. 13B, a write address is input to the MRAM 10 (address "0000" is input). Since the ACT signal is "0", the dynamic NOR logic circuit 442 of the detector circuit 440 is in an inactive state and does not function. Further, the write word line control signal (WWL signal) at the time of writing is inverted via the NAND circuit 444 and output as the DETECT signal, and the output DETECT signal controls the word line. That is, at this point in time, the word line [00] is waiting to be controlled by the WWL signal, and the word line [00] remains at "0".

Subsequently, as illustrated in Fig. 13C, the WDATA signal is input to MRAM 10. At this point in time, since the WRITE signal is "0", the tri-state buffers 502 that drive the bit lines (ABLT line and ABLC line) are in the high impedance state, and the WDATA signals are not transmitted to the bit lines (ABLT [0] line and ABLC [0] line).

Subsequently, as illustrated in Fig. 13D, the WRITE signal is set to "1". In this way, the tri-state buffers 502 are activated, and the WDATA signals are transmitted to the bit lines (ABLT line and ABLC line). Then, as illustrated in Fig. 13E, the write word line control signal (WWL signal) is also set to "1" at the time of writing. In this way, the word line [00] is also set to "1".

Subsequently, as illustrated in Fig. 13F, a current flows from the ABLT line which is set to "1" to the WCTL line which is set to "0", and the current flows through the MTJ element 320a. Note that this state is maintained in accordance with the amount of current and the time required for rewriting the MTJ element 320a.

Subsequently, as illustrated in Fig. 13G, the WCLT (VGND) line is changed from "0" to "1". In this way, a current flows from the WCLT line to the ABLC line which is set to "0", and the current flows through the MTJ element 320b. Note that this state is maintained in accordance with the amount of current and the time required for rewriting the MTJ element 320b.

Then, as illustrated in Fig. 13H, the WWL signal is returned to "0" and the word line [00] is set to "0". In this way, no current flows through the MTJ elements 320a and 320b.

Subsequently, as illustrated in Fig. 13I, the WRITE signal is set to "0" and the WCLT (VGND) line is set to "0". Note that, in the present embodiment, the switching may not be strictly simultaneous. Then, as illustrated in Fig. 13J, the ABLT line and the ABLC line are short-circuited, and the potentials of the ABLT line and the ABLC line are lowered to half of the power supply potential (VDD/2). In this way, the MRAM 10 returns to the initial state.

As described above, according to the present embodiment, it is possible to provide the MRAM (storage device) 10 which can read data with high accuracy while avoiding an increase in the chip area, and which can operate at a higher speed if the power supply voltage is the same and can operate at a lower power supply voltage if the operation speed is the same.

Specifically, in the present embodiment, in one memory cell 310 serving as one storage unit, the difference between the MTJ element 320 in the high resistance state and the MTJ element 320 in the low resistance state is detected, and thus the amount of difference is large. Therefore, in the present embodiment, reading of the amount of difference becomes easier than in the related art, and it is thus possible to read the data with high accuracy. As a result, according to the present embodiment, the probability of the occurrence of the reading error is low, and it is not necessary to provide a redundant circuit or an error correction circuit in the MRAM 10. Therefore, according to the present embodiment, it is possible to avoid an increase in the chip area and an increase in the power consumption. Furthermore, according to the present embodiment, unlike the related art, it is not necessary to provide the reference cell.

Furthermore, in the present embodiment, since the amount of difference to be read is larger than that in the related art, the potential of the output on the high resistance side of the two outputs of the sense amplifier 410 rises quickly and reaches the potential corresponding to the logical value of "1" quickly. Therefore, the sense amplifier 410 according to the present embodiment can quickly read the data stored in the memory cell 310. Therefore, according to the present embodiment, the MRAM 10 can operate at a higher speed than the related art if the voltage is the same, and can operate at a lower voltage than the related art if the operation speed is the same. In addition, in the present embodiment, when the reading of data is completed, the word line is immediately and autonomously set to "0" by the detector circuit 440 electrically connected to the sense amplifier 410, and the access transistor 330 corresponding to the MTJ element 320, from which the data has been read, can be quickly turned off. Therefore, according to the present embodiment, the current flowing from the sense amplifier 410 to the MTJ element 320 can be suppressed to the minimum necessary, and the power consumption of the MRAM 10 can be reduced and the reliability can be improved.

### 2. Second Embodiment

### 2.1 Background

Next, with reference to Figs. 14 to 16, the background that led the inventors of the present disclosure to create a second embodiment of the present disclosure will be described. Fig. 14 is a diagram illustrating a configuration of a logical operation circuit 60a according to the related art, and Fig. 15 is a diagram illustrating a circuit configuration of the logical operation circuit 60a according to the related art. Further, Fig. 16 is a diagram for explaining an outline of a logical operation circuit 60 according to the second embodiment of the present disclosure.

The logical operation circuit 60 described here includes the memory cell 310 including the MTJ element 320 and a logic circuit that performs a logical operation. The logical operation circuit 60 can store a logical value in the built-in memory cell 310 in advance, and can use the built-in logic circuit to perform a logical operation based on data input from the outside and the stored logical value.

More specifically, as illustrated in Fig. 14, the logical operation circuit 60a according to the related art mainly includes, for example, a memory cell 35 including the MTJ element 320, the write circuit 500 that writes the logical value to the memory cells 35, a logic circuit 65 that performs a logical operation, and a sense amplifier 410a that reads the operation result.

Various circuit configurations have been proposed as the logical operation circuit 60a described above. Fig. 15 illustrates a circuit configuration example of the logical operation circuit 60a proposed in the past. The logical operation circuit 60a illustrated in Fig. 15 includes the memory cell 310 including two of the MTJ elements 320, the sense amplifier 410a, and the logic circuit 65 that performs an AND/NAND logical operation by a Schmitt trigger precharge sense amplifier (ST-PCSA). Then, in the example of Fig. 15, the sense amplifier 410a is grounded (connected to the ground) through the memory cell 310, that is, the MTJ elements 320. Although various configurations have been proposed as the circuit configuration of the sense amplifier 410a used in the logical operation circuit 60a, the sense amplifier 410a has been grounded through the MTJ element 320 in all of the proposed circuit configurations.

As described above, since the MTJ element 320 has a resistance of about several kΩ even in the low resistance state, the operation of the sense amplifier 410a is not stabilized when the sense amplifier 410a is grounded via the MTJ element 320. Thus, in the logical operation circuit 60a according to the related art, it takes time to determine the operation result, and also, it is difficult to perform a low-voltage operation.

Thus, in view of such circumstances, the inventors of the present disclosure have created the second embodiment of the present disclosure described below, while using the configuration of the first embodiment of the present disclosure described above. Fig. 16 illustrates a schematic configuration of the logical operation circuit 60 according to the second embodiment of the present disclosure. As illustrated on the left side of Fig. 16, in the present embodiment, the logical operation circuit 60 mainly includes a differential logic tree cell 70 including two of the MTJ elements 320 and the logic circuit 65, the sense amplifier 410, and the write circuit 500, as in the related art. Here, the differential logic tree cell 70 refers to a unit cell including a storage element that stores a logical value, and the differential-type logic circuit 65 that can perform a logical operation based on the logical value and data input from the outside. In the present embodiment, as illustrated on the right side of Fig. 16, the sense amplifier 410 is grounded without passing through the MTJ element 320. Specifically, in the present embodiment, the sense amplifier 410 includes two of the inverters 420 including input and output terminals connected to each other in a loop, as in the sense amplifier 410 of the first embodiment of the present disclosure. Then, the sense amplifier 410 itself is directly connected to the ground (grounded). Therefore, according to the present embodiment, the operation of the sense amplifier 410 is stabilized. As a result, according to the present embodiment, the logical operation circuit 60 can quickly determine the operation result (high-speed operation), and is also suitable for the low-voltage operation.

Furthermore, with respect to the logical operation circuit 60a, a specific configuration of the write circuit 500 for writing data to the storage element has not been proposed. Thus, in the second embodiment of the present disclosure, the write circuit 500 that is suitable in consideration of the characteristics of the MTJ element 320 will also be described. Details of the second embodiment of the present disclosure will be described below in order.

### 2.2 Detailed Configuration

### Logical Operation Circuit 60

First, with reference to Fig. 17, an overall configuration of the logical operation circuit 60 according to the second embodiment of the present disclosure will be described. Fig. 17 is a diagram illustrating a configuration example of the logical operation circuit 60 according to the present embodiment. As illustrated in Fig. 17, in the present embodiment, the logical operation circuit 60 mainly includes the differential logic tree cell (MTJ Logic Tree) 70, the sense amplifier 410, and the write circuit 500. As described above, the differential logic tree cell 70 is the unit cell including the storage element that stores the logical value, and the differential-type logic circuit 65 that can perform the logical operation based on the logical value and the data input from the outside. Details of each of components constituting the logical operation circuit 60 according to the present embodiment will be described below in order.

### Differential Logic Tree Cell 70

First, a configuration of the differential logic tree cell 70 according to the present embodiment will be described with reference to Figs. 18 to 24. Fig. 18 is a diagram illustrating a circuit configuration example of the differential logic tree cell 70 according to the present embodiment, and Fig. 19 is a diagram illustrating a circuit configuration example of a differential-type logic circuit 700 according to the present embodiment. Further, Figs. 20 to 22 are diagrams illustrating an operation of the differential logic tree cell 70 according to the present embodiment, and Figs. 23 and 24 are diagrams illustrating a circuit configuration example of the differential logic tree cell 70 according to a modification example of the present embodiment.

As illustrated in Fig. 18, in the present embodiment, the differential logic tree cell 70 mainly includes a memory cell 720 including two of the MTJ elements (first and second magnetic storage elements) 320 and two access transistors (first and second access transistors) 710, and the differential-type logic circuit (differential logic circuit) 700 that performs a logical operation with use of a logical value (data) stored in the memory cell 720 and external data (a0, a0b) input from the outside.

In the present embodiment, the memory cell 720 has a 2T2R configuration, similarly to the memory cell 310 according to the first embodiment. Specifically, one of the terminals (first terminal) of each of the MTJ elements 320 is electrically connected to one of the source and the drain (first terminal) of a corresponding one of the access transistors 710 constituted of an n-type MOS transistor, and to the differential-type logic circuit 700. The other terminal (second terminal) of the MTJ element 320 is electrically connected to the write control line (WCTL line) (common reference potential line) extending in the column direction. Further, the other of the source and the drain (second terminal) of each of the access transistors 710 is electrically connected to a corresponding one of a WBLT line and a WBLC line (first and second bit lines) extending in the column direction. The gate (third terminal) of the access transistor 710 is electrically connected to a write word line (WWL line) that extends in the row direction and transmits a WWL signal. In the present embodiment, the above-described memory cell 720 stores the logical value used for the operation in a nonvolatile manner.

Further, in the example illustrated in Fig. 18, the differential-type logic circuit 700 is a logic circuit that performs the AND/NAND logical operation. The differential-type logic circuit 700 performs the AND/NAND logical operation with use of the logical value stored in the memory cell 720 and the external data (a0, a0b) that are input from the outside and are inverted from each other, and the operation result is read by the sense amplifier 410 via out and out_b (read bit line, RBLT line, RBLC line).

Note that, in the present embodiment, the differential-type logic circuit 700 is not limited to the logic circuit that performs the AND/NAND logical operation as illustrated in Fig. 18, and may be a logic circuit that performs an XNOR/XOR logical operation as illustrated in Fig. 19. Alternatively, the differential-type logic circuit 700 may be a logic circuit that performs an OR/NOR logical operation as illustrated in Fig. 19. That is, in the present embodiment, by changing the wiring of four n-type MOS transistors constituting the differential-type logic circuit 700, it is possible to easily form a logic circuit that performs different logical operations.

Further, in the present embodiment, the data is stored in one memory cell 720 serving as one storage unit, similarly to the first embodiment of the present disclosure described above. Specifically, in the present embodiment, as illustrated on the left side of Figs. 20 to 22, the memory cell 720 stores data with the logical value of "0" by setting the one MTJ element 320a to the low resistance state (L) and setting the other MTJ element 320b to the high resistance state (H). Further, in the present embodiment, the memory cell 720 stores data with the logical value of "1" by setting the one MTJ element 320a to the high resistance state (H) and the other MTJ element 320b to the low resistance state (L).

Then, as illustrated on the right side of Figs. 20 to 22, when the external data (a0, a0b) is input to the differential-type logic circuit 700 and the sense amplifier 410 described later is operated, of two transistors that have been turned on by the input of the external data with the logical value of "1", a large amount of current flows through the transistor connected to the MTJ element 320 in the low resistance state (indicated by the thick arrow) and a small amount of current flows through the transistor connected to the MTJ element 320 in the high resistance state (indicated by the thin arrow). Then, a difference is generated between the magnitudes of two currents flowing out from the sense amplifier 410 to the two lines (out and out_b), and the potential of the output from the high resistance side of the two lines of the sense amplifier 410 quickly rises and quickly reaches the potential corresponding to the logical value of "1". On the other hand, the potential of the output from the low resistance side quickly reaches the potential corresponding to the logical value of "0". In other words, the differential logic tree cell 70 can perform the logical operation while reading the values of the MTJ elements 320a and 320b.

Further, in the present embodiment, as illustrated in Fig. 23, a transmission gate 712, in which an n-type MOS transistor and a p-type MOS transistor are combined, may be used instead of the access transistor 710 constituted of the n-type MOS transistor. At this time, a WWL_B line electrically connected to the gate of the p-type MOS transistor always has a polarity opposite from that of a signal of the WWL line. In this way, by using the transmission gate 712 in which the n-type MOS transistor and the p-type MOS transistor are combined, the current caused to flow when writing a logical value to the MTJ element 320 can be increased, and thus the writing to the MTJ element 320 can be performed in a short time.

Further, in the present embodiment, as illustrated in Fig. 24, a p-type MOS transistor 714 may be used instead of the access transistor 710 constituted of the n-type MOS transistor. At this time, the WWL_B line electrically connected to the gate of the p-type MOS transistor always has a polarity opposite from that of the signal of the WWL line.

### Sense Amplifier 410

Next, a configuration of the sense amplifier 410 according to the present embodiment will be described with reference to Figs. 25 and 26. Fig. 25 is a diagram illustrating a circuit configuration example of the sense amplifier 410 according to the present embodiment, and Fig. 26 is a circuit configuration example of the sense amplifier 410 according to a modification example of the present embodiment.

The sense amplifier 410 according to the present embodiment is a circuit that reads the operation result of the differential logic tree cell 70. Specifically, as illustrated in Fig. 25, the sense amplifier 410 is a digital differential sense amplifier, and is electrically connected to out and out_b of the differential logic tree cell 70, and is further electrically connected to the NOR-type RS latch circuit 430 and an inverter 432.

In the present embodiment, as illustrated in Fig. 25, the sense amplifier 410 includes two of the inverters 420 including input and output terminals connected to each other in a loop, the n-type MOS transistor 414 that electrically connects the output terminals of the two inverters 420 to each other, and the p-type MOS transistor 412 that electrically connects the two inverters to the power supply, as in the first embodiment. Further, in the present embodiment, the sense amplifier 410 includes the inverter 416 electrically connected to the gates of the n-type MOS transistor 414 and the p-type MOS transistor 412. Then, in the present embodiment, the operation result read out to the sense amplifier 410 is temporarily held in the NOR-type RS latch circuit 470, and then inverted by the inverter 432 and output.

As described in the first embodiment, the sense amplifier 410 according to the present embodiment can operate at a higher speed than the related art if the voltage is the same. Further, in the present embodiment, the sense amplifier 410 is grounded without passing through the MTJ element 320 (differential logic tree cell 70). Specifically, in the present embodiment, the sense amplifier 410 itself is directly connected to the ground (grounded). Thus, in the present embodiment, the operation of the sense amplifier 410 is stabilized. Therefore, according to the present embodiment, the logical operation circuit 60 can quickly determine the operation result (high-speed operation), and is also suitable for the low-voltage operation. Note that details of the read operation according to the present embodiment will be described later.

Further, in the present embodiment, as illustrated in Fig. 26, the sense amplifier 410 may further include a shutoff circuit 448 for autonomously shutting off the sense amplifier 410. The shutoff circuit 448 according to the present embodiment is constituted similarly to the detector circuit 440 according to the first embodiment of the present disclosure. Specifically, the shutoff circuit 448 is electrically connected to the sense amplifier 410 and includes the dynamic NOR logic circuit 442 including two input terminals. In the present embodiment, by providing the above-described shutoff circuit 448, the sense amplifier 410 can be immediately and autonomously turned off quickly when the reading of the operation result is completed. Therefore, according to the present embodiment, the current flowing from the sense amplifier 410 can be suppressed to the minimum necessary, and as a result, the power consumption of the logical operation circuit 60 can be reduced and the reliability thereof can be improved. Note that, as in the first embodiment, the shutoff circuit 448 may include the inverter loop 450 constituted of two inverters including input and output terminals connected to each other in a loop.

### Write Circuit 500

Next, a configuration of the write circuit 500 according to the present embodiment will be described. The write circuit 500 according to the present embodiment is a circuit for writing the logical value to the memory cell 720, and is constituted similarly to the write circuit 500 according to the first embodiment illustrated in Fig. 11.

Specifically, in the present embodiment also, as illustrated in Fig. 11, the write circuit 500 includes the two tri-state buffers 502 electrically connected to the WBLT line and the WBLC line (first and second bit lines), respectively, and the inverter (common reference potential line control circuit) 504 electrically connected to the WCTL line (common reference potential line). Since details of the configuration of the write circuit 500 according to the present embodiment are the same as those of the first embodiment, the description thereof is omitted. Note that details of the write operation according to the present embodiment will be described later.

Note that, in the embodiment of the present disclosure, the logical operation circuit 60 is not limited to the mode illustrated in Figs. 17 to 26 and can be modified to various modes.

### 2.3 Operation

### Read Operation

Next, with reference to Figs. 27A to 27I, an example of the read operation of the logical operation circuit 60 according to the present embodiment will be described. Figs. 27A to 27I are diagrams for explaining the read operation of the logical operation circuit 60 according to the present embodiment.

First, as illustrated in Fig. 27A, during the read operation, the WWL line is set to "0", the WRITE signal is set to "0", the WCLT line is set to "0", and the WDATA signal is set to "0" or "1". Note that, in the example described below, it is assumed that the MTJ element 320a is in the high resistance state ("H"), and the MTJ element 320b is in the low resistance state ("L"). Further, at this time, the tri-state buffer 502 of the write circuit 500 is in the high impedance ("Z") state.

Subsequently, the input data pair (a0, a0b) to which the external data is input is set to "0, 0" in the initial state. Then, when the logical value of "0" is input to the logical operation circuit 60 as the external data, "0, 1" is input to the input data pair (a0, a0b), and when the logical value of "1" is input as the external data, "1, 0" is input to the input data pair (a0, a0b). Note that, in the example described below, as illustrated in Fig. 27B, the logical value of "1" ("1, 0") is input as external data to the logical operation circuit 60.

Subsequently, as illustrated in Fig. 27C, the ACT signal is changed from "0" to "1". In this way, the sense amplifier 410 is activated, and a current starts to flow from an RBLT line and an RBLC line, which are a pair of read bit lines, toward the MTJ elements 320a and 320b. As illustrated in Fig. 27C, since the MTJ element 320b is in the low resistance state ("L"), the current flowing to the RBLC line becomes large (indicated by the thick arrow).

Subsequently, as illustrated in Fig. 27D, the potential of the RBLT line rises more quickly than that of the RBLC line due to a difference between the currents flowing through the RBLT line and the RBLC line, respectively, and the difference in the potential is quickly amplified by the sense amplifier 410, and the RBLC line is set to the logical value of "1". Then, as illustrated in Fig. 27E, the value of the logical value of "1" is held by the RS latch circuit 470 connected to the sense amplifier 410. In this way, the logical operation circuit 60 according to the present embodiment can perform an operation (in this example, an AND operation) with use of the logical values stored in the MTJ elements 320a and 320b and the external data.

Subsequently, as illustrated in Fig. 27F, the ACT signal is returned to "0". In this way, the current flowing from the sense amplifier 410 is stopped. Further, since the RBLT line and the RBLC line are short-circuited by the sense amplifier 410, after the potential temporarily drops to half of the power supply potential (VDD/2), the charge remaining in the parasitic capacitance of the sense amplifier 410 flows to GND via the MTJ elements 320, and thus the potentials of the RBLT line and the RBLC line immediately become 0 V. Subsequently, as illustrated in Fig. 27G, the input data pair (a0, a0b) is returned to "0, 0" to be in the initial state. At this time, the value of the logical value of "1" as the operation result is held by the RS latch circuit 470.

Note that, in the present embodiment, as illustrated in Fig. 27H, after the operation result is determined, the input data pair (a0, a0b) may be returned to "0, 0" without returning the ACT signal to "0". In the present embodiment, since the looped inverters 420 of the sense amplifier 410 are grounded, no problem occurs in the operation even in this case. Thereafter, as illustrated in Fig. 27I, the ACT signal is returned to "0". In this way, the RBLT line and the RBLC line are short-circuited. Thus, the charge remaining in the RBLT line and the RBLC line moves from the high voltage side to the low voltage side, and the potentials of the RBLT line and the RBLC line temporarily drop to half of the power supply potential (VDD/2). Then, the potentials of the RBLT line and the RBLC line drop to the vicinity of the threshold value (Vth) of the n-type MOS transistor 414, which is short-circuiting the inverters 420 of the sense amplifier 410, and then reach 0 V due to the leakage current. That is, it takes time until the potentials of the RBLT line and the RBLC line reach 0 V. Thus, by performing the next operation before the potentials reach 0 V, the remaining charge can be reused, and thus the power consumption can be reduced by the voltage generated by the charge remaining at that time. In addition, in this way, it is not necessary to wait for the potentials of the RBLT line and the RBLC line to reach 0 V, and thus the operation time can also be shortened.

### Write Operation

Next, with reference to Figs. 28A to 28F, an example of the write operation of the logical operation circuit 60 according to the present embodiment will be described. Figs. 28A to 28F are diagrams for explaining the write operation of the logical operation circuit 60 according to the present embodiment.

First, as illustrated in Fig. 28A, the ACT signal is set to "0", and the input data pair (a0, a0b) to which the external data is input is set to "0, 0". In this way, the sense amplifier 410 is deactivated and disconnected from the MTJ elements 320a and 320b.

Subsequently, as illustrated in Fig. 28B, the WRITE signal is set to "1". In this way, the values of the WBLT line and the WBLC line, which are write bit lines, are changed in accordance with the value of the write data (WDATA) signal. Then, as illustrated in Fig. 28C, the value of the WWL signal of the write word line (WWL line) is set to "1". In this way, a current flows through the MTJ element 320a, and a logical value is written thereto.

Subsequently, as illustrated in Fig. 28D, the WCTL line is switched from "0" to "1". In this way, this time, a current opposite from that in the MTJ element 320a illustrated in Fig. 28C flows in the MTJ element 320b, and a logical value is written thereto.

As illustrated in Fig. 28E, the value of the WWL signal of the WWL line is changed from "1" to "0". In this way, no current flows through the MTJ elements 320a and 320b. Then, as illustrated in Fig. 28F, the WRITE signal and the WCTL line are also set to "0". In this way, the logical operation circuit 60 returns to the initial state.

As described above, in the present embodiment, the sense amplifier 410 is grounded without passing through the MTJ element 320 (differential logic tree cell 70). Specifically, in the present embodiment, the sense amplifier 410 itself is directly connected to the ground. Therefore, according to the present embodiment, the operation of the sense amplifier 410 is stabilized. As a result, according to the present embodiment, the logical operation circuit 60 can quickly determine the operation result (high-speed operation), and is also suitable for the low-voltage operation.

### 2.4 Modification Example

Next, a configuration of the logical operation circuit 60 according to a modification example of the present embodiment will be described with reference to Figs. 29 and 30. Figs. 29 and 30 are diagrams illustrating a configuration example of the logical operation circuit 60 according to the modification example of the present embodiment.

In the present embodiment, the logical operation circuit 60 is not limited to the mode illustrated in Fig. 17 and can be modified to various modes. For example, as illustrated in Fig. 29, one sense amplifier 410 and one write circuit 500 may be shared by a plurality of the differential logic tree cells 70 arranged along the column direction. Then, the plurality of differential logic tree cells 70 arrayed in the column direction may be arrayed in the row direction to form a differential logic tree cell array. In this case, of the plurality of differential logic tree cells 70, one of the plurality of differential logic tree cells 70 exclusively becomes an operation target. Therefore, the external input data of the differential logic tree cell 70, which is not targeted, becomes "0, 0", and the WRITE signal becomes "0".

Further, for example, as illustrated in Fig. 30, one sense amplifier 410 may be provided for one differential logic tree cell 70, and a plurality of pairs of the differential logic tree cell 70 and the sense amplifier 410 may be provided. In this way, operations can be performed simultaneously in the plurality of differential logic tree cells 70. Even in this case, one write circuit 500 may be shared by the plurality of pairs of the differential logic tree cell 70 and the sense amplifier 410. Further, in the example of Fig. 30, the circuit illustrated in Fig. 30 may be provided, but with respect to the operation mode, an operation mode may be adopted in which only one differential logic tree cell 70 is exclusively operated by a control signal from the outside as in the example of Fig. 29. In this way, it is possible to appropriately adjust the computing performance and the power consumption so that they meet the constraint conditions of the computing capability and the power consumption required at each time.

### 3. Third Embodiment

### 3.1 Background

Next, the background that led the inventors of the present disclosure to create a third embodiment of the present disclosure will be described. A computing in memory (CiM) is a device in which a computational circuit for performing operations is incorporated in a storage device, and has been actively studied in recent years.

However, since the CiMs proposed so far use a volatile static random access memory (SRAM) as a storage element, when the CiM is started (powered on), a logical value used for the operation has to be read from an external storage device. Thus, the CiM using the SRAM has a problem that the processing time is increased by the time required for the reading.

Further, many of the CiMs proposed so far have been a CiM including an analog computational circuit. The analog CiM is a method of expressing a result of a product-sum operation by the potential of a bit line, and an analog-digital (AD) converter is used to convert the voltage value of the result into a binary number (digital value). Specifically, data input to the analog CiM is converted into one pulse, and the time width of the pulse corresponds to the value of the data. Then, the analog CiM lowers the potential of the bit line in accordance with a lowering amount (gradient) per a predetermined time period, during a time length indicated by the pulse width. Further, in the analog CiM, every time data is input, the conversion into the pulse and the reduction in the potential of the bit line are repeated, and the finally determined potential of the bit line is converted into a binary number, whereby the result of the product-sum operation can be obtained.

Since the analog CiM is an analog type, it is difficult to change the potential of the bit line with ideal linearity, and an error is likely to occur in the result of the product-sum operation. Further, in the analog CiM, the error may occur also due to parasitic resistance and parasitic capacitance generated in a circuit constituting the analog CiM, and due to manufacturing variations of circuit elements. In addition, in the analog CiM, the error is likely to occur in the pulse width for indicating the value of the data, or in the binary number converted by the AD converter due to noise from the power supply or the like. Further, due to such an error, when the analog CiM is used for general purposes, it has an effective computational accuracy (bit width) of as low as about 8 bits. Furthermore, when a difference is small between the potential of the bit line in the initial state and the potential (limit potential) of the bit line corresponding to the operation result that can be finally obtained, the above-described error becomes larger, and thus the power supply potential needs to be increased. Therefore, it is difficult for the analog CiM to perform the low-voltage operation and to suppress the power consumption.

Therefore, in view of such circumstances, the inventors of the present disclosure have created the third embodiment of the present disclosure described below, while using the configurations of the first and second embodiments of the present disclosure described above. In the present embodiment, since a nonvolatile MRAM is used as the storage element, when the CiM is activated (powered on), it is not necessary to read the logical value used for the operation from the external storage device, and the operation can be immediately started. Thus, according to the present embodiment, since the operation can be started immediately, the power consumption can be suppressed to a low level. Further, since the present embodiment is a CiM including a digital computational circuit, the product-sum operation is performed in binary, and thus the AD converter is not necessary. In addition, in the present embodiment, since the CiM is a digital type, it produces fewer errors, it can be freely expanded to have any computational accuracy, and it can perform the low-voltage operation. Details of the third embodiment of the present disclosure will be described below in order.

### 3.2 Detailed Configuration

### CiM 80

First, an overall configuration of a CiM 80 according to the third embodiment of the present disclosure will be described with reference to Figs. 31 and 32. Fig. 31 is a diagram illustrating a configuration example of the CiM 80 according to the present embodiment, and Fig. 32 is a diagram illustrating a configuration example of main components of the CiM 80 according to the present embodiment.

As illustrated in Fig. 31, the CiM (a storage device with a computation function) 80 according to the present embodiment includes a plurality of the differential logic tree cells 70. Each of the plurality of differential logic tree cells 70 includes the memory cell 720 and the differential-type logic circuit (differential logic circuit) 700 that performs a logical operation (AND) with use of a coefficient (data) stored in the memory cell 720 and external data input from the outside, as in the second embodiment described above. In the CiM 80, the plurality of differential logic tree cells 70 are arrayed in a matrix along the row direction and the column direction, and one sense amplifier 410 and one write circuit 500 are shared by the plurality of differential logic tree cells 70 arrayed along the column direction. Therefore, each of the sense amplifiers 410 can read respective operation results of the plurality of differential logic tree cells 70 located in the same column, and the write circuit 500 can write the coefficient to each of the plurality of differential logic tree cells 70 located in the same column. Further, as illustrated in Fig. 31, the plurality of differential logic tree cells 70 sharing the one sense amplifier 410 and the one write circuit 500 are arranged along the row direction to form a cell array 82.

Further, in Fig. 32 in which the cell array 82 is illustrated, the plurality of differential logic tree cells 70 are connected to each other by an input data line to which the external data (a, ab) is input and the write word line (WWL line). In the CiM 80, the external data input from the outside is distributed to each of the plurality of differential logic tree cells 70 arranged in the row direction, and operations are performed in parallel between the external data and a coefficient (W) stored in each of the differential logic tree cells 70. Then, the respective operation results of the differential logic tree cells 70 are read by the respective sense amplifiers 410.

Then, as illustrated in Fig. 31, the CiM 80 includes an adder (digital computational circuit) (Shift & Adder) 90 that adds the operation results read by each of the sense amplifiers 410. The adder 90 sequentially accumulates the operation results of each of the differential logic tree cells 70 to obtain a multiplication operation result or a product-sum operation result. Details of each of the components constituting the CiM 80 according to the present embodiment will be described below in order.

### Differential Logic Tree Cell 70

First, with reference to Figs. 33 and 34, a configuration of the differential logic tree cell 70 according to the present embodiment will be described. Fig. 33 is a diagram illustrating a circuit configuration example of the differential logic tree cell 70 according to the present embodiment, and Fig. 34 is a diagram illustrating an operation of the differential logic tree cell 70 according to the present embodiment.

The differential logic tree cell 70 according to the present embodiment uses the differential logic tree cell 70 according to the second embodiment of the present disclosure described above. Specifically, as illustrated in Fig. 33, in the present embodiment, the differential logic tree cell 70 mainly includes the memory cell 720 including two of the MTJ elements (first and second magnetic storage elements) 320 and two of the access transistors (first and second access transistors) 710, and the differential-type logic circuit (differential logic circuit) 700 that performs a logical operation with use of the coefficient stored in the memory cell 720 and the external data (a0, a0b) input from the outside. In the memory cell 720 according to the present embodiment, as in the memory cell 720 according to the second embodiment, the one terminal (first terminal) of each of the MTJ elements 320 is electrically connected to one of the source and the drain (first terminal) of a corresponding one of the access transistors 710 constituted of the n-type MOS transistor, and to the differential-type logic circuit 700. The other terminal (second terminal) of the MTJ element 320 is electrically connected to the WCTL line (common reference potential line) extending in the column direction. Further, the other of the source and the drain (second terminal) of each of the access transistors 710 is electrically connected to a corresponding one of a WBLT line and a WBLC line (first and second bit lines) extending in the column direction. The gate (third terminal) of the access transistor 710 is electrically connected to the write word line (WWL line) extending in the row direction. In the present embodiment, the above-described memory cell 720 stores the coefficient or the like used for the operation in a nonvolatile manner.

Further, the differential-type logic circuit 700 is a logic circuit that performs the AND/NAND logical operation. An operation result of the differential-type logic circuit 700 including the logic circuit for performing the AND/NAND logical operation corresponds to a partial product in binary multiplication. Note that, in the present embodiment, the differential-type logic circuit 700 is not limited to the logic circuit that performs the AND/NAND logical operation, and may be a logic circuit that performs the XNOR/XOR logical operation, or may be a logic circuit that performs the OR/NOR logical operation, or these logic circuits may be mixed in one CiM. The differential-type logic circuit 700 performs the AND/NAND logical operation with use of the coefficient stored in the memory cell 720, and the external data (a0, a0b) that are input from the outside and are inverted from each other, and the operation result is read by the sense amplifier 410 via the read bit line, the RBLT line, and the RBLC line.

Further, in the present embodiment also, the data is stored in one memory cell 720 serving as one storage unit, similarly to the first and second embodiments of the present disclosure described above. Specifically, as illustrated on the left side of Fig. 34, the memory cell 720 stores data with the logical value of "0" by setting the one MTJ element 320a to the low resistance state (L) and setting the other MTJ element 320b to the high resistance state (H). Further, in the present embodiment, the memory cell 720 stores data with the logical value of "1" by setting the one MTJ element 320a to the high resistance state (H) and setting the other MTJ element 320b to the low resistance state (L).

Then, as illustrated on the right side of Fig. 34, when the external data (a0, a0b) is input to the differential-type logic circuit 700 and the sense amplifier 410 described later is operated, of two transistors in the differential-type logic circuit 700 that have been turned on by the input of the external data with the logical value of "1", a large amount of current flows through the transistor connected to the MTJ element 320 in the low resistance state (indicated by the thick arrows) and a small amount of current flows through the transistor connected to the MTJ element 320 in the high resistance state (indicated by the thin arrows). Then, a difference is generated between the magnitudes of two currents flowing from the sense amplifier 410 to the RBLT line and the RBLC line, respectively, and, of the RBLT line or the RBLC line, the potential of the output on the high resistance side rises quickly and reaches the potential corresponding to the logical value of "1" quickly. On the other hand, the potential of the output from the low resistance side quickly reaches the potential corresponding to the logical value of "0". In other words, the differential logic tree cell 70 can perform the logical operation while reading the values of the MTJ elements 320a and 320b.

### Sense Amplifier 410

Next, a configuration of the sense amplifier 410 according to the present embodiment will be described. The sense amplifier 410 according to the present embodiment uses the sense amplifier 410 according to the second embodiment of the present disclosure described above, and is constituted similarly to the sense amplifier 410 according to the second embodiment illustrated in Fig. 25. The sense amplifier 410 is a digital differential sense amplifier, and is electrically connected to the RBLT line and the RBLC line of the differential logic tree cell 70, and is further electrically connected to the NOR-type RS latch circuit 430. The operation result read out to the sense amplifier 410 is temporarily held in the NOR-type RS latch circuit 470. More specifically, by synchronizing the ACT signal that controls the sense amplifier 410 with the clock that controls the adder 90, the operation result is held for one cycle of the clock. This is convenient for the adder 90 connected later because a sufficient operation time can be secured. Note that, here, details of the configuration of the sense amplifier 410 according to the present embodiment are the same as those of the sense amplifier 410 according to the second embodiment of the present disclosure described above, and thus the description thereof is omitted.

### Write Circuit 500

Next, a configuration of the write circuit 500 according to the present embodiment will be described. The write circuit 500 according to the present embodiment is a circuit for writing the logical value to the memory cell 720, and is constituted similarly to the write circuit 500 according to the first embodiment illustrated in Fig. 11. Therefore, the description of the details of the configuration of the write circuit 500 according to the present embodiment is omitted.

### Adder 90

Next, a configuration of the adder 90 according to the present embodiment will be described with reference to Fig. 35. Fig. 35 is a diagram illustrating a circuit configuration example of the adder 90 according to the present embodiment. As illustrated in Fig. 35, the adder 90 according to the present embodiment is constituted of a shift circuit 96, an adder circuit 92, and a register 94. The adder 90 adds operation results output from the differential logic tree cells 70 one after another. More specifically, in the adder 90, the shift circuit 96 logically shifts an operation result immediately preceding an operation result held in the register 94 to the left by one bit (corresponding to doubling in binary). Then, the adder circuit 92 adds the shifted immediately preceding operation result and a newly input operation result.

That is, since the operation result of the differential-type logic circuit 700 including the logic circuit for performing the AND/NAND logical operation corresponds to the partial product in binary multiplication, the adder 90 is a digital integrating circuit, and a multiplication result can be obtained by summing the partial products by the adder 90.

Note that, in the embodiment of the present disclosure, the CiM 80 is not limited to the mode illustrated in Figs. 31 to 35 and can be modified to various modes.

### 3.3 Operation

Next, with reference to Figs. 36A to 36E, an example of the operation of the CiM 80 according to the present embodiment will be described. Figs. 36A to 36E are diagrams for explaining the operation of the CiM 80 according to the present embodiment. In the example described here, it is assumed that the CiM 80 performs binary multiplication.

First, as illustrated in Fig. 36A, it is assumed that coefficients "W3, W2, W1, WO" of 4-bit binary numbers are stored in the differential logic tree cells 70 bit by bit along the row direction. Further, external data D to be multiplied by the coefficients W are also 4-bit binary numbers "D3, D2, D1, D0".

Subsequently, as illustrated in Fig. 36B, D3, which is the most significant bit, is first input to the CiM 80. Then, as illustrated in Fig. 36C, an AND operation result of the coefficients "W3, W2, W1, WO" stored in the respective differential logic tree cells 70 and "D3" is output.

Subsequently, as illustrated in Fig. 36D, "D2" is input to the CiM 80, and an AND operation result of the coefficients "W3, W2, W1, WO" stored in the respective differential logic tree cells 70 and "D2" is output. Further, the CiM 80 shifts the immediately preceding operation result "D3 and W3, W2, W1, WO" to the left by one bit, and then adds the current operation result "D2 and W3, W2, W1, WO" thereto. As described above, in binary operation, shifting one bit to the left corresponds to doubling.

Then, as illustrated in Fig. 36E, by performing the same operation for "D1" and "D0", the CiM 80 can obtain a multiplication result.

As described above, in the present embodiment, since the nonvolatile MTJ element 320 is used as the storage element, when the CiM 80 is activated (powered on), it is not necessary to read the coefficient from the external storage device, and the operation can be immediately started. Therefore, according to the present embodiment, the operation can be started immediately, and thus the power consumption can be suppressed to a low level. Further, since the present embodiment is the CiM 80 including the digital computational circuit, the product-sum operation can be performed with binary numbers, and the AD converter is not necessary. In addition, in the present embodiment, since the CiM 80 is a digital type, it produces fewer errors, it can be freely expanded to have any computational accuracy, and it can perform the low-voltage operation.

### 3.4 Modification Example

Next, with reference to Fig. 37, the CiM 80 according to a modification example of the present embodiment will be described. Fig. 37 is a diagram illustrating a configuration example of the CiM 80 according to the modification example of the present embodiment.

For example, when 8-bit coefficients W "W7, W6, W5, W4, W3, W2, W1, WO" are handled, eight of the differential logic tree cells 70 may be arranged in the row direction as illustrated in Fig. 37. Then, in this case, the CiM 80 repeats the above-described operation eight times. In this way, the CiM 80 according to the present embodiment can be easily expanded to any computational accuracy (bit width).

Further, in the present embodiment, the differential logic tree cells 70 may be arranged in the column direction, and in this case, different coefficients may be stored in the respective differential logic tree cells 70. Then, a target row may be selected at each time, and the differential logic tree cells 70 of the selected row may perform the operation.

### 3.5 Application Example

Next, with reference to Figs. 38 and 39, an application of the CiM 80 according to the present embodiment will be described. Fig. 38 is a diagram illustrating an example of processing in electronic equipment according to the present embodiment, and Fig. 39 is a diagram for explaining a comparison of processing times between the present embodiment and the related art.

In recent years, electronic equipment has been proposed in which a sensor device such as an imaging device (image sensor) or a sound collecting device is combined with a processing device for analyzing (recognition-processing) sensing data acquired by the sensor device. For example, a system equipped with artificial intelligence (AI) for advanced analysis processing is called edge AI and is being actively studied. In such a device, as illustrated in Fig. 38, "Always On Device" (driving device) and "Normally Off Device" are used to suppress an increase in the power consumption. Although the "Always On Device" always analyzes the sensing data, the analysis is limited to rough analysis, thereby suppressing the power consumption. Then, when the "Always On Device" captures predetermined sensing data, the "Always On Device" sends a trigger to the "Normally Off Device" to activate the "Normally Off Device". The "Normally Off Device" can perform advanced analysis, but does not operate without receiving the trigger in order to suppress the power consumption.

In a case where a CiM using the volatile SRAM according to the related art is used as the above-described "Normally Off Device", when the CiM is started (powered on), the logical value (coefficient) must be read from an external storage device. Therefore, as illustrated in the upper part of Fig. 39, the CiM using the SRAM requires a long processing time.

Therefore, when the CiM 80 according to the present embodiment is used as the "Normally Off Device", since the nonvolatile MTJ elements 320 are used, when the CiM 80 is activated (powered on), it is not necessary to read the logical value from the external storage device as illustrated in the lower part of Fig. 39. That is, when the CiM 80 according to the present embodiment is used as the "Normally Off Device", the operation can be started immediately. Therefore, according to the present embodiment, since the operation can be started immediately, the processing time can be shortened, and the power consumption can be suppressed to a low level.

### 4. Supplement

Although the preferred embodiments of the present disclosure have been described above in detail with reference to the accompanying drawings, the technical scope of the present disclosure is not limited to such examples. It is apparent that a person having ordinary knowledge in the technical field of the present disclosure can conceive various changes or modifications within the scope of the technical idea described in the claims, and it is understood that these also naturally belong to the technical scope of the present disclosure.

Further, the effects described in the present specification are merely explanatory or exemplary and are not limiting. That is, the technology according to the present disclosure can exhibit other effects that are apparent to those skilled in the art from the description of the present specification, together with or instead of the above-described effects.

Note that the present technology can also adopt configurations such as the following.
(1) A logical operation circuit including a differential logic tree cell, and a digital differential sense amplifier configured to read an operation result of the differential logic tree cell, in which the differential logic tree cell includes a memory cell including first and second magnetic storage elements configured to store data in response to a change in a resistance value, and a differential logic circuit configured to perform a logical operation with use of the data stored in the memory cell and external data input from the outside, and the digital differential sense amplifier is grounded without passing through the differential logic tree cell.
(2) The logical operation circuit according to (1) described above, in which each of the first and second magnetic storage elements includes a fixed layer in which a magnetization direction is fixed, a free layer in which the magnetization direction is variable, and a nonmagnetic layer sandwiched between the fixed layer and the free layer.
(3) The logical operation circuit according to (1) or (2) described above, in which the digital differential sense amplifier includes two inverters including input and output terminals connected to each other in a loop, a first switch configured to connect the output terminals of the two inverters to each other, and a second switch configured to connect the two inverters to a power supply.
(4) The logical operation circuit according to (3) described above, in which the digital differential sense amplifier further includes a shutoff circuit configured to shut off the digital differential sense amplifier autonomously, and the shutoff circuit is constituted of a dynamic NOR logic circuit electrically connected to the digital differential sense amplifier.
(5) The logical operation circuit according to (4) described above, in which the dynamic NOR logic circuit further includes two inverters electrically connected to an output node of the dynamic NOR logic circuit and configured to hold a state of the output node, the two inverters including input and output terminals connected to each other in a loop.
(6) The logical operation circuit according to any one of (3) to (5) described above, in which the digital differential sense amplifier is electrically connected to a NOR-type RS latch circuit.
(7) The logical operation circuit according to any one of (1) to (6) described above, in which the memory cell further includes first and second access transistors electrically connected to the first and second magnetic storage elements, respectively.
(8) The logical operation circuit according to (7) described above, in which the first and second access transistors are constituted of n-type MOS transistors.
(9) The logical operation circuit according to (7) described above, in which the first and second access transistors are constituted of p-type MOS transistors.
(10) The logical operation circuit according to (7) described above, in which the first and second access transistors are constituted of transmission gates.
(11) The logical operation circuit according to any one of (7) to (10) described above, in which first terminals of the first and second magnetic storage elements are electrically connected to first terminals of the first and second access transistors, respectively, second terminals of the first and second magnetic storage elements are electrically connected to a common reference potential line extending in a column direction, second terminals of the first and second access transistors are electrically connected to first and second bit lines extending in the column direction, respectively, and third terminals of the first and second access transistors are electrically connected to a word line extending in a row direction.
(12) The logical operation circuit according to (11) described above further including a write circuit configured to write data to the memory cell, in which the write circuit writes a first value to the memory cell by applying a voltage to cause a current to flow from the first terminal to the second terminal of the first magnetic storage element and applying a voltage to cause a current to flow from the second terminal to the first terminal of the second magnetic storage element, and writes a second value to the memory cell by applying a voltage to cause a current to flow from the second terminal to the first terminal of the first magnetic storage element and applying a voltage to cause a current to flow from the first terminal to the second terminal of the second magnetic storage element.
(13) The logical operation circuit according to (12) described above, in which the write circuit includes two tri-state buffers electrically connected to the first and second bit lines, respectively, and a common reference potential line control circuit electrically connected to the common reference potential line.
(14) The logical operation circuit according to any one of (1) to (13) described above, in which the differential logic circuit is constituted of an AND/NAND circuit.
(15) The logical operation circuit according to any one of (1) to (13) described above, in which the differential logic circuit is constituted of an OR/NOR circuit.
(16) The logical operation circuit according to any one of (1) to (13) described above, in which the differential logic circuit is constituted of an XNOR/XOR circuit.
(17) The logical operation circuit according to (12) described above further including a differential logic tree cell array in which a plurality of the differential logic tree cells are arrayed.
(18) The logical operation circuit according to (17) described above, in which the digital differential sense amplifier is provided for each of the differential logic tree cells.
(19) The logical operation circuit according to (17) described above, in which the digital differential sense amplifier is shared by the plurality of differential logic tree cells.
(20) The logical operation circuit according to (17) described above, in which the write circuit is shared by the plurality of differential logic tree cells.

### Reference Signs List

10 MRAM
20 Word line driver
30 Memory cell array
35, 310, 310a, 720 Memory cell
40 Peripheral circuit unit
60, 60a Logical operation circuit
65 Logic circuit
70 Differential logic tree cell
80 CiM
82 Cell array
90 Adder
92 Adder circuit
94 Register
96 Shift circuit
202 Address decoder
204, 212, 416, 420, 432, 504 Inverter
210, 444 NAND circuit
320, 320a, 320b MTJ element
322 Free layer
   324 Nonmagnetic layer
326 Fixed layer
330, 710 Access transistor
350 Multiplexer circuit
352 Transmission gate
400 Read circuit
410, 410a Sense amplifier
412, 414, 445, 446, 714 Transistor
418 NOR circuit
430, 470 RS latch circuit
440 Detector circuit
442 Dynamic NOR logic circuit
448 Shutoff circuit
450 Inverter loop
500 Write circuit
502 Tri-state buffer
700 Differential-type logic circuit
712 Transmission gate

## Claims

1. A logical operation circuit comprising:
a differential logic tree cell; and
a digital differential sense amplifier configured to read an operation result of the differential logic tree cell, wherein
the differential logic tree cell includes
a memory cell including first and second magnetic storage elements configured to store data in response to a change in a resistance value, and
a differential logic circuit configured to perform a logical operation with use of the data stored in the memory cell and external data input from the outside, and
the digital differential sense amplifier is grounded without passing through the differential logic tree cell.

2. The logical operation circuit according to claim 1, wherein
each of the first and second magnetic storage elements includes
a fixed layer in which a magnetization direction is fixed,
a free layer in which the magnetization direction is variable, and
a nonmagnetic layer sandwiched between the fixed layer and the free layer.

3. The logical operation circuit according to claim 1, wherein
the digital differential sense amplifier includes
two inverters including input and output terminals connected to each other in a loop,
a first switch configured to connect the output terminals of the two inverters to each other, and
a second switch configured to connect the two inverters to a power supply.

4. The logical operation circuit according to claim 3, wherein
the digital differential sense amplifier further includes a shutoff circuit configured to shut off the digital differential sense amplifier autonomously, and
the shutoff circuit is constituted of a dynamic NOR logic circuit electrically connected to the digital differential sense amplifier.

5. The logical operation circuit according to claim 4, wherein
the dynamic NOR logic circuit further includes two inverters electrically connected to an output node of the dynamic NOR logic circuit and configured to hold a state of the output node, the two inverters including input and output terminals connected to each other in a loop.

6. The logical operation circuit according to claim 3, wherein
the digital differential sense amplifier is electrically connected to a NOR-type RS latch circuit.

7. The logical operation circuit according to claim 1, wherein
the memory cell further includes
first and second access transistors electrically connected to the first and second magnetic storage elements, respectively.

8. The logical operation circuit according to claim 7, wherein
the first and second access transistors are constituted of n-type MOS transistors.

9. The logical operation circuit according to claim 7, wherein
the first and second access transistors are constituted of p-type MOS transistors.

10. The logical operation circuit according to claim 7, wherein
the first and second access transistors are constituted of transmission gates.

11. The logical operation circuit according to claim 7, wherein
first terminals of the first and second magnetic storage elements are electrically connected to first terminals of the first and second access transistors, respectively,
second terminals of the first and second magnetic storage elements are electrically connected to a common reference potential line extending in a column direction,
second terminals of the first and second access transistors are electrically connected to first and second bit lines extending in the column direction, respectively, and
third terminals of the first and second access transistors are electrically connected to a word line extending in a row direction.

12. The logical operation circuit according to claim 11, further comprising:
a write circuit configured to write data to the memory cell, wherein
the write circuit
writes a first value to the memory cell by applying a voltage to cause a current to flow from the first terminal to the second terminal of the first magnetic storage element and applying a voltage to cause a current to flow from the second terminal to the first terminal of the second magnetic storage element, and
writes a second value to the memory cell by applying a voltage to cause a current to flow from the second terminal to the first terminal of the first magnetic storage element and applying a voltage to cause a current to flow from the first terminal to the second terminal of the second magnetic storage element.

13. The logical operation circuit according to claim 12, wherein
the write circuit includes
two tri-state buffers electrically connected to the first and second bit lines, respectively, and
a common reference potential line control circuit electrically connected to the common reference potential line.

14. The logical operation circuit according to claim 1, wherein
the differential logic circuit is constituted of an AND/NAND circuit.

15. The logical operation circuit according to claim 1, wherein
the differential logic circuit is constituted of an OR/NOR circuit.

16. The logical operation circuit according to claim 1, wherein
the differential logic circuit is constituted of an XNOR/XOR circuit.

17. The logical operation circuit according to claim 12, further comprising:
a differential logic tree cell array in which a plurality of the differential logic tree cells are arrayed.

18. The logical operation circuit according to claim 17, wherein
the digital differential sense amplifier is provided for each of the differential logic tree cells.

19. The logical operation circuit according to claim 17, wherein
the digital differential sense amplifier is shared by the plurality of differential logic tree cells.

20. The logical operation circuit according to claim 17, wherein
the write circuit is shared by the plurality of differential logic tree cells.
